# EUROPEAN PATENT APPLICATION

(11) **EP 4 579 348 A2**
(43) Date of publication of application: **02.07.2025**
(21) Application number: 24221446.8
(22) Date of filing: 19.12.2024
(51) Int. Cl.: G03F 7/075, G03F 7/09

(54) **COMPOUND FOR FORMING METAL-CONTAINING FILM, COMPOSITION FOR FORMING METAL-CONTAINING FILM, AND PATTERNING PROCESS**

(30) Priority: 26.12.2023 JP 2023218982
(71) Applicant: Shin-Etsu Chemical Co., Ltd., Chiyoda-ku Tokyo 100-0005 (JP)
(72) Inventor: Kobayashi, Naoki, Niigata (JP); Nagamachi, Nobuhiro, Niigata (JP); Ishiwata, Kenta, Niigata (JP); Takizawa, Kanata, Niigata (JP); Iwamori, Shohei, Niigata (JP); Kori, Daisuke, Niigata (JP)
(74) Representative: Sonnenhauser, Thomas Martin

(57) **Abstract**

The present invention is a compound for forming a metal-containing film, containing: at least one kind of metal atom (a) selected from the group consisting of Ti, Zr, and Hf; and a polydentate ligand coordinated to the metal atom (a), where the polydentate ligand is derived from a compound (b) having 1 to 50 carbon atoms and being substituted with at least one kind of halogen atom selected from the group consisting of a chlorine atom, a bromine atom, and an iodine atom. This can provide: a compound for forming a metal-containing film to be used for forming a metal-containing film that can contribute to the improvement of sensitivity while maintaining the LWR of the upper layer resist; a composition for forming a metal-containing film, containing the compound; and a patterning process using the composition.

## Description

### TECHNICAL FIELD

The present invention relates to: a compound for forming a metal-containing film, usable for fine patterning according to a multilayer resist method in a semiconductor device manufacturing process; a composition for forming a metal-containing film, containing the compound; and a patterning process using the composition.

### BACKGROUND ART

Along with high integration and high processing speed of LSI, the effort to reduce the pattern rule is in rapid progress. In particular, logic devices, used in smartphones etc., drive forward the miniaturization technology, and 10-nm node logic devices are mass-produced using multiple exposure (multi-patterning lithography) processes according to ArF lithography.

In subsequent 7-nm node and 5-nm node lithography, problems of high costs due to multiple exposure and overlay accuracy in multiple exposure have become apparent, and the arrival of EUV lithography, in which the number of times exposure is performed can be reduced, is expected.

An extreme ultraviolet ray (EUV) having a wavelength of 13.5 nm has a short wavelength, being less than 1/10 of the wavelength of an ArF excimer laser, being 193 nm. Therefore, EUV lithography has a high contrast of light, and high resolution is expected. EUV has a short wavelength and has a high energy density, and therefore, an acid generator is sensitive to a small amount of photons. The number of photons in EUV exposure is said to be 1/14 of the number in ArF exposure. In EUV exposure, the phenomenon that line width roughness (LWR) and the critical dimension uniformity (CDU) of holes are degraded due to variation in photons is regarded as a problem (Non Patent Document 1). Furthermore, uneven distribution and agglomeration of the base polymer or acid generator and the possibility that the diffusion of acid generated from an acid generator may have an effect have also been pointed out.

As a measure against the problems, for example, LWR can be reduced by lowering the post exposure baking (PEB) temperature, but this degrades the sensitivity of the EUV resist. Furthermore, LWR is also reduced by increasing the added amount of a quencher, but sensitivity is also degraded in this method. To put EUV resists to practical use, it is necessary to break the trade-off relationship between sensitivity and LWR.

### CITATION LIST

### NON PATENT LITERATURE

Non Patent Document 1: SPIE, Vol. 3331, p. 531 (1998)

### SUMMARY OF INVENTION

### TECHNICAL PROBLEM

To put EUV lithography to practical use as a process for mass-producing semiconductor devices, many problems need to be solved, and a property that particularly needs improvement is high sensitivity while maintaining LWR.

The present invention has been made in view of the above-described circumstances. An object of the present invention is to provide: a compound for forming a metal-containing film to be used for forming a metal-containing film that can contribute to the improvement of sensitivity while maintaining the LWR of the upper layer resist; a composition for forming a metal-containing film, containing the compound; and a patterning process using the composition.

### SOLUTION TO PROBLEM

To achieve the object, the present invention provides a compound for forming a metal-containing film, comprising:
at least one kind of metal atom (a) selected from the group consisting of Ti, Zr, and Hf; and a polydentate ligand coordinated to the metal atom (a),
wherein the polydentate ligand is derived from a compound (b) having 1 to 50 carbon atoms and being substituted with at least one kind of halogen atom selected from the group consisting of a chlorine atom, a bromine atom, and an iodine atom.

Such a compound for forming a metal-containing film makes it possible to obtain a composition for forming a resist underlayer film or middle layer film that can contribute to the improvement of sensitivity while maintaining the LWR of the upper layer resist.

The compound (b) preferably contains any of structures represented by the following general formulae (b-1) to (b-4), 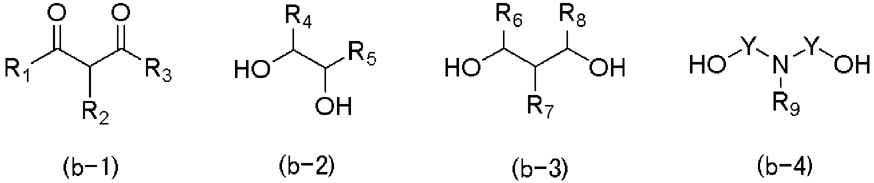 wherein R₁ to R₃ each represent a hydrogen atom or a monovalent organic group having 1 to 30 carbon atoms and optionally containing any of a chlorine atom, a bromine atom, and an iodine atom; R₄ and R₅ each represent a hydrogen atom or a monovalent organic group having 1 to 30 carbon atoms and optionally containing any of a chlorine atom, a bromine atom, and an iodine atom; R₆ to R₉ each represent a hydrogen atom or a monovalent organic group having 1 to 30 carbon atoms and optionally containing any of a chlorine atom, a bromine atom, and an iodine atom; Y represents a divalent organic group having 1 to 10 carbon atoms; the R₄ and the R₅ in the general formula (b-2), being adjacent to each other, are optionally bonded to each other to form an unsaturated or saturated cyclic structure; and compounds of the general formulae (b-1) to (b-4) contain at least one of any of a chlorine atom, a bromine atom, and an iodine atom.

Such a compound for forming a metal-containing film makes it possible to obtain a composition for forming a resist underlayer film or middle layer film that can contribute to the improvement of sensitivity while maintaining the LWR of the upper layer resist.

In this case, the compounds represented by the general formulae (b-1) to (b-4) preferably contain at least one of an aromatic ring, a heteroaromatic ring, and an alicyclic structure.

Such a compound for forming a metal-containing film has excellent heat resistance, and therefore, the amount of sublimation product when forming a metal oxide film can be reduced, and it is also possible to form a metal oxide film that contains many chlorine atoms, bromine atoms, or iodine atoms.

Furthermore, in this case, the compound represented by the general formulae (b-1) to (b-4) preferably contains a structure represented by the following formula (1), 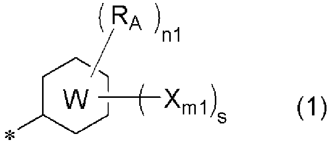 wherein Xₘ₁ represents any of a chlorine atom, a bromine atom, and an iodine atom, or a monovalent organic group having 1 to 10 carbon atoms and containing any of a chlorine atom, a bromine atom, and an iodine atom; W represents an organic group having 5 to 20 carbon atoms and containing any of an aromatic ring, a heteroaromatic ring, and an alicyclic structure; R_{A} is selected from a linear alkyl group having 1 to 10 carbon atoms, a branched alkyl group having 1 to 10 carbon atoms, an alkoxy group having 1 to 10 carbon atoms, a hydroxy group, a halogen atom, and a halogenated alkyl group having 1 to 10 carbon atoms; "s" is 1 to 5; and "n₁" is 0 to 2.

Such a compound for forming a metal-containing film has excellent heat resistance, and therefore, the amount of sublimation product when forming a metal oxide film can be reduced, and it is also possible to form a metal oxide film that contains many chlorine atoms, bromine atoms, or iodine atoms.

The compound for forming a metal-containing film preferably further comprises a ligand (c) derived from a silicon compound represented by the following general formula (2), 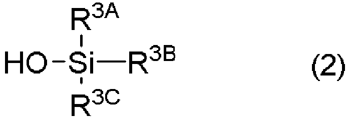 wherein R^{3A}, R^{3B}, and R^{3C} each represent any organic group selected from an organic group having 1 to 30 carbon atoms and having any crosslinking group of structures represented by the following general formulae (c-1) to (c-3), a substituted or unsubstituted alkyl group having 1 to 20 carbon atoms, and an aryl group having 1 to 20 carbon atoms, 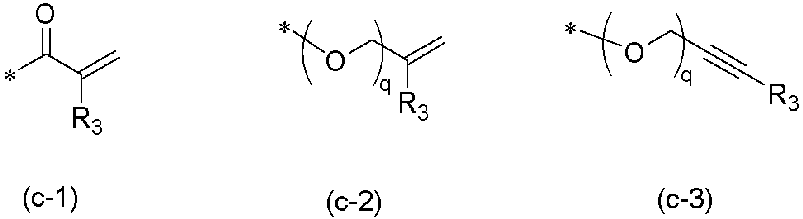 wherein R₃ represents a hydrogen atom or a monovalent organic group having 1 to 10 carbon atoms; "q" represents 0 or 1; and "*" represents an attachment point.

Such a compound for forming a metal-containing film has excellent stability, and the storage life stability of a composition for forming a resist underlayer film or middle layer film can be improved.

The compound for forming a metal-containing film preferably further comprises a ligand having one or more crosslinkable groups selected from a vinyl group, an allyl group, an allyloxy group, an ethynyl group, a propargyl group, a propargyloxy group, an epoxy group, and an oxetanyl group.

In this case, the compound (b) preferably further has one or more crosslinkable groups selected from a vinyl group, an allyl group, an allyloxy group, an ethynyl group, a propargyl group, a propargyloxy group, an epoxy group, and an oxetanyl group.

Such a compound for forming a metal-containing film has better heat resistance, and therefore, the amount of sublimation product when forming a metal oxide film can be reduced, and it is also possible to form a metal oxide film that contains many chlorine atoms, bromine atoms, or iodine atoms.

The compound for forming a metal-containing film is preferably a reaction product between: a metal-containing compound containing one or more selected from a metal compound represented by the following formula (3) and a hydrolysis product, condensate, and hydrolysis condensate of the metal compound represented by the following formula (3); and the compound represented by any of the formulae (b-1) to (b-4),

LₐMX_{b} (3)

wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR^{a}R^{b}, R^{a} and R^{b} each independently represent a hydrogen atom or a monovalent organic group having 1 to 20 carbon atoms, and a+b is 2 to 4, "a" and "b" each representing an integer of 0 to 4.

When such a metal compound is used, it is possible to form a metal-containing film having better dry etching resistance to fluorine gas and oxygen gas.

The compound (b) preferably contains one or more chlorine atoms.

Such a compound for forming a metal-containing film makes it possible to obtain a composition for forming a resist underlayer film or middle layer film that can contribute to the improvement of sensitivity while maintaining the LWR of the upper layer resist.

The compound (b) preferably contains one or more bromine atoms.

Such a compound for forming a metal-containing film makes it possible to obtain a composition for forming a resist underlayer film or middle layer film that can contribute to the improvement of sensitivity while maintaining the LWR of the upper layer resist.

The compound (b) preferably contains one or more iodine atoms.

Such a compound for forming a metal-containing film makes it possible to obtain a composition for forming a resist underlayer film or middle layer film that can contribute to the improvement of sensitivity while maintaining the LWR of the upper layer resist.

In addition, the present invention provides a composition for forming a metal-containing film, the composition functioning as a resist underlayer film material or a resist middle layer film material used in manufacturing a semiconductor, the composition comprising:
(A) the above-described compound for forming a metal-containing film; and
(B) an organic solvent.

Such a composition for forming a metal-containing film makes it possible to form a resist underlayer film or middle layer film that can contribute to the improvement of sensitivity while maintaining the LWR of the upper layer resist.

The composition can further comprise one or more of (C) a crosslinking agent, (D) an acid generator, and (E) a surfactant.

The composition for forming a metal-containing film containing one or more of the additives has better coating property, dry etching resistance, and filling and/or planarizing property.

The organic solvent (B) is preferably a mixture of one or more kinds of organic solvent having a boiling point of lower than 180°C and one or more kinds of (B') a high-boiling-point solvent, being an organic solvent having a boiling point of 180°C or higher.

When flowability is imparted to the compound for forming a metal-containing film by a high-boiling-point solvent being contained, it is possible to suppress the generation of dryness-induced coating defects in the composition for forming a metal-containing film.

In addition, the present invention provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) forming an organic resist underlayer film on a substrate to be processed;
(II-2) applying the above-described composition for forming a metal-containing film onto the organic resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed.

The patterning process by way of the three-layer resist process makes it possible to form fine patterns on the body to be processed with high accuracy.

The present invention also provides a patterning process for forming a pattern in a substrate to be processed, comprising the steps of:
(III-1) applying the above-described composition for forming a metal-containing film onto a substrate to be processed, followed by heating to form a metal-containing film;
(III-2) forming an inorganic hard mask middle layer film selected from a silicon-containing resist middle layer film, a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with high accuracy.

The present invention also provides a patterning process for forming a pattern in a substrate to be processed, comprising the steps of:
(IV-1) applying the above-described composition for forming a metal-containing film onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed.

The patterning process by way of the multilayer resist process makes it possible to form fine patterns on the body to be processed with high accuracy.

The pattern exposure in the step (1-3) is preferably performed using EUV light.

The pattern exposure in the step (II-4) is preferably performed using EUV light.

The pattern exposure in the step (III-5) is preferably performed using EUV light.

The pattern exposure in the step (IV-5) is preferably performed using EUV light.

The inventive compound for forming a metal-containing film contains a chlorine atom, a bromine atom, or an iodine atom, having high light absorption, in addition to a metal atom having high light absorption, and therefore, it is possible to form a resist underlayer film or middle layer film that can contribute to improvement in sensitivity while maintaining the LWR of the upper layer resist in EUV lithography.

### ADVANTAGEOUS EFFECTS OF INVENTION

The inventive compound for forming a metal-containing film contains any atom out of a chlorine atom, a bromine atom, or an iodine atom, having high light absorption, in addition to a metal atom having high light absorption, and therefore, has a characteristic that a sensitizing effect can be expected by virtue of secondary electrons generated from the atoms during exposure in EUV lithography.

Furthermore, a metal-containing film obtained by the present invention can achieve high etching selectivity relative to an organic material, and therefore, a formed photoresist pattern can be transferred successively to a metal-containing film and an organic underlayer film or a CVD organic hard mask by using a dry etching process. In particular, in recent semiconductor device manufacturing processes, in which miniaturization has progressed, there is a tendency to reduce the film thickness of photoresist films to prevent pattern collapse after development, and this has made it difficult to transfer patterns to resist underlayer films. However, when the inventive composition for forming a metal-containing film is used, it is possible to suppress the deformation of a photoresist pattern during dry etching even when a thin photoresist film is used as an etching mask, and transfer the pattern to a substrate with high precision.

### BRIEF DESCRIPTION OF DRAWINGS

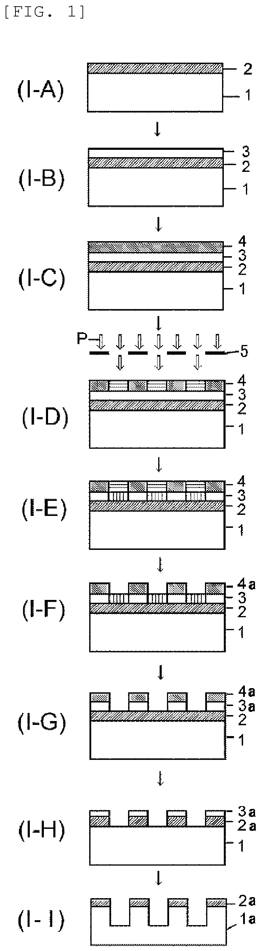

FIG. 1 is a flow diagram showing the inventive patterning process.

### DESCRIPTION OF EMBODIMENTS

As stated above, there have been demands for the development of: a compound for forming a metal-containing film to be used for forming a resist underlayer film or middle layer film that can contribute to the improvement of sensitivity while maintaining the LWR of the upper layer resist; a composition for forming a metal-containing film, containing the compound; and a patterning process using the composition.

To achieve the object, the present inventors have earnestly studied and found out that by introducing any of a chlorine atom, a bromine atom, and an iodine atom into a compound for forming a metal-containing film, it is possible to improve sensitivity without the LWR of the upper layer resist being degraded, and completed the present invention.

That is, the present invention is a compound for forming a metal-containing film, comprising:
at least one kind of metal atom (a) selected from the group consisting of Ti, Zr, and Hf; and a polydentate ligand coordinated to the metal atom (a),
wherein the polydentate ligand is derived from a compound (b) having 1 to 50 carbon atoms and being substituted with at least one kind of halogen atom selected from the group consisting of a chlorine atom, a bromine atom, and an iodine atom.

Hereinafter, the present invention will be described in detail, but the present invention is not limited thereto.

### <Compound for Forming Metal-Containing Film>

The inventive compound for forming a metal-containing film contains: at least one kind of metal atom (a) selected from the group consisting of Ti, Zr, and Hf; and a polydentate ligand coordinated to the metal atom (a). In addition, the polydentate ligand is derived from a compound (b) having 1 to 50 carbon atoms and being substituted with at least one kind of halogen atom selected from the group consisting of a chlorine atom, a bromine atom, and an iodine atom.

The inventive compound for forming a metal-containing film has a characteristic that the compound contains the following constituents.
(a) At least one kind of metal atom selected from the group consisting of Ti, Zr, and Hf.
(b) A polydentate ligand derived from a compound (b) having 1 to 50 carbon atoms and being substituted with at least one kind of halogen atom selected from the group consisting of a chlorine atom, a bromine atom, and an iodine atom.

The metal atom contained in the compound for forming a metal-containing film is at least one kind of metal atom selected from the group consisting of Ti, Zr, and Hf. From the viewpoint of productivity, any of Ti, Zr, and Hf is contained, and from the viewpoint of improving productivity and the sensitivity of the resist, it is preferable that either Ti or Hf is contained.

The ligand coordinated to the compound for forming a metal-containing film may contain different structures, and a ligand that satisfies the features of the above (b) and a common ligand other than that ligand may be contained.

The compound (b) is preferably any of structures represented by the following general formulae (b-1) to (b-4) .

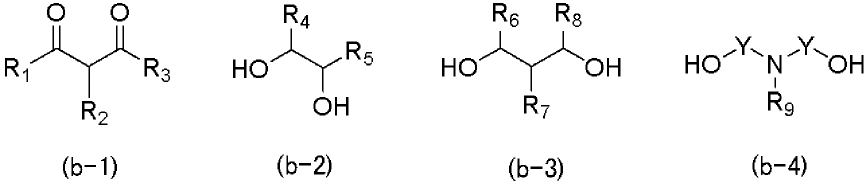

In the general formulae, R₁ to R₃ each represent a hydrogen atom or a monovalent organic group having 1 to 30 carbon atoms and optionally containing any of a chlorine atom, a bromine atom, and an iodine atom; R₄ and R₅ each represent a hydrogen atom or a monovalent organic group having 1 to 30 carbon atoms and optionally containing any of a chlorine atom, a bromine atom, and an iodine atom; R₆ to R₉ each represent a hydrogen atom or a monovalent organic group having 1 to 30 carbon atoms and optionally containing any of a chlorine atom, a bromine atom, and an iodine atom; Y represents a divalent organic group having 1 to 10 carbon atoms; the R₄ and the R₅ in the general formula (b-2), being adjacent to each other, are optionally bonded to each other to form an unsaturated or saturated cyclic structure; and compounds of the general formulae (b-1) to (b-4) contain at least one of any of a chlorine atom, a bromine atom, and an iodine atom.

In the inventive compound for forming a metal-containing film, a chlorine atom, a bromine atom, or an iodine atom is contained in a polydentate ligand, which is excellent in coordination to a metal atom, and therefore, when the compound is contained in a composition for forming a metal-containing film, it is possible to form a metal-containing film containing many halogen atoms.

Furthermore, the compounds represented by the general formulae (b-1) to (b-4) preferably contain at least one of an aromatic ring, a heteroaromatic ring, and an alicyclic structure.

When the compound (b), containing a halogen atom, used for a ligand includes a structure described above, the heat resistance of the ligand containing a chlorine atom, a bromine atom, or an iodine atom is further improved, and therefore, when the compound is contained in a composition for forming a metal-containing film, it is possible to form a metal-containing film containing many chlorine atoms, bromine atoms, or iodine atoms.

The compound represented by the general formulae (b-1) to (b-4) preferably contains a structure represented by the following formula (1).

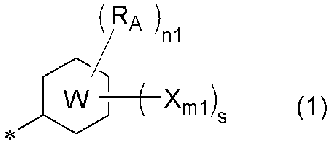

In the formula, Xₘ₁ represents any of a chlorine atom, a bromine atom, and an iodine atom, or a monovalent organic group having 1 to 10 carbon atoms and containing any of a chlorine atom, a bromine atom, and an iodine atom; W represents an organic group having 5 to 20 carbon atoms and containing any of an aromatic ring, a heteroaromatic ring, and an alicyclic structure; R_{A} is selected from a linear alkyl group having 1 to 10 carbon atoms, a branched alkyl group having 1 to 10 carbon atoms, an alkoxy group having 1 to 10 carbon atoms, a hydroxy group, a halogen atom, and a halogenated alkyl group having 1 to 10 carbon atoms; "s" is 1 to 5; and "n₁" is 0 to 2.

In the formula (1), Xₘ₁ represents any of a chlorine atom, a bromine atom, and an iodine atom, or a monovalent organic group having 1 to 10 carbon atoms and containing any of a chlorine atom, a bromine atom, and an iodine atom, preferably any of a chlorine atom, a bromine atom, and an iodine atom, or a halogenated hydrocarbon group containing any of a chlorine atom, a bromine atom, and an iodine atom and having 1 to 10 carbon atoms. Specific examples of the halogenated hydrocarbon group include halogenated alkyl groups, such as a chloromethyl group, a bromoethyl group, an iodoethyl group, etc. When the Xₘ₁ contains multiple halogen atoms, the halogen atoms may be identical to or different from each other.

In the formula (1), R_{A} is preferably a linear alkyl group having 1 to 10 carbon atoms, a branched alkyl group having 1 to 10 carbon atoms, or a halogenated alkyl group having 1 to 10 carbon atoms.

In the formula (1), W is preferably an organic group having 5 to 20 carbon atoms and containing any of an aromatic ring, a heteroaromatic ring, and an alicyclic structure, more preferably a structure shown below.

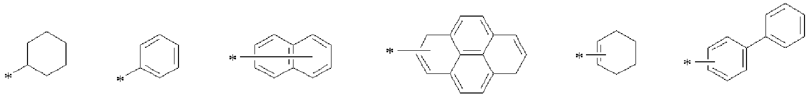

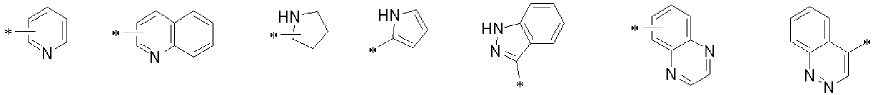

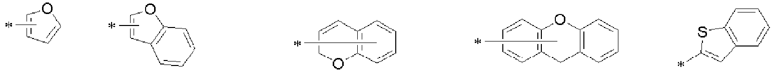

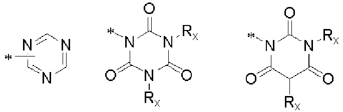

In the formulae, Rₓ is either of the above R_{A} and Xₘ₁, and "*" represents an attachment point.

From the viewpoint of heat resistance, the W in the formula (1) further preferably contains an aromatic ring, and from the viewpoint of productivity, W is particularly preferably a benzene ring.

Preferable examples of the structures represented by the formulae (b-1) to (b-4) include the following.

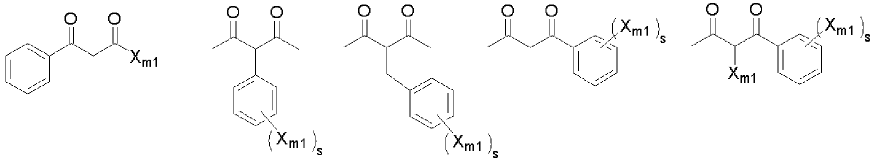

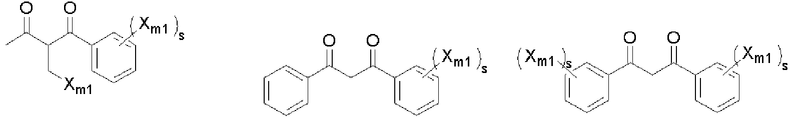

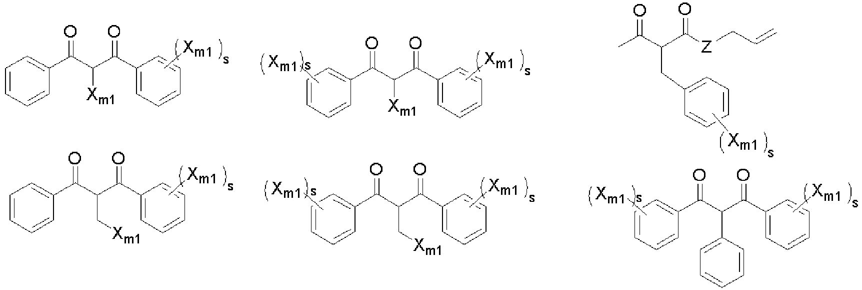

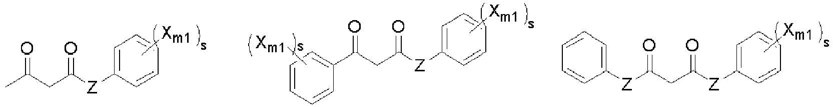

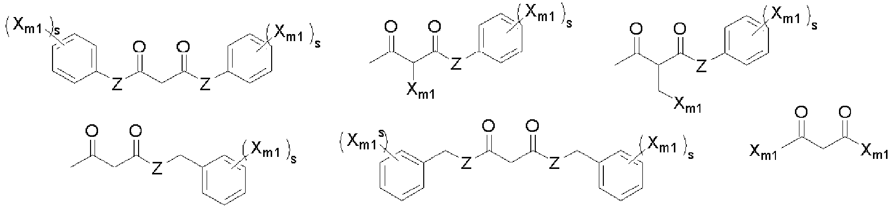

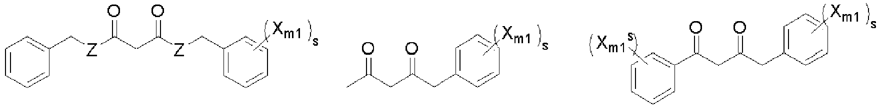

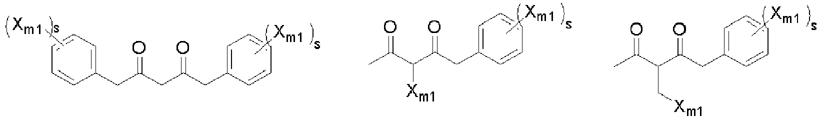

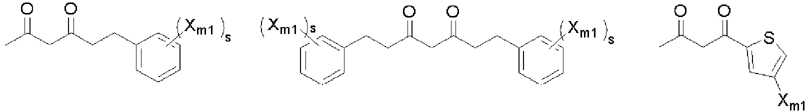

In the formulae, Xₘ₁ and "s" are as defined in the formula (1); the Z in the formulae represents either an oxygen atom or a secondary amine; and any of the hydrogen atoms in the above formulae may be substituted with a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms. 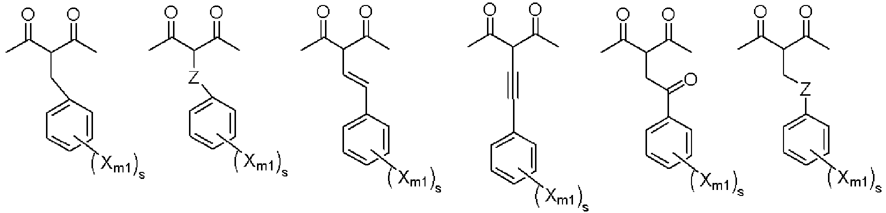 In the formulae, Xₘ₁ and "s" are as defined in the formula (1); the Z in the formulae represents either an oxygen atom or a secondary amine; and any of the hydrogen atoms in the above formulae may be substituted with a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms.

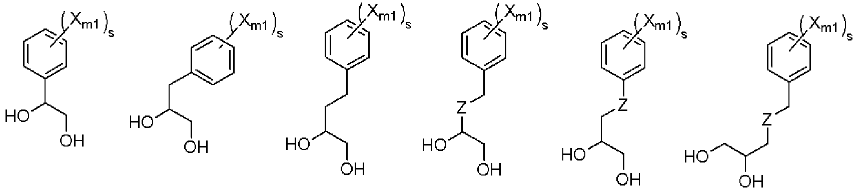

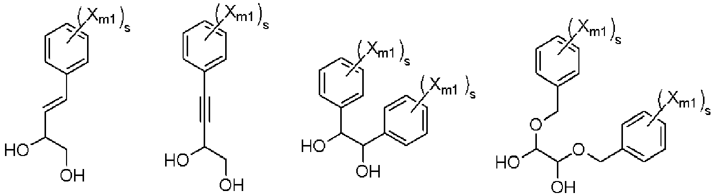

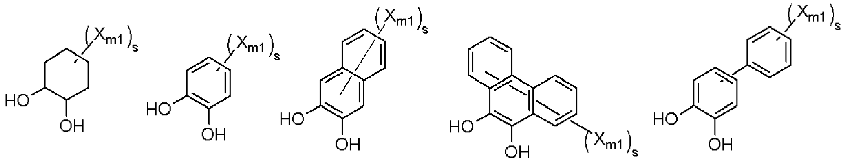

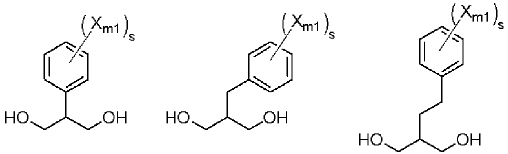

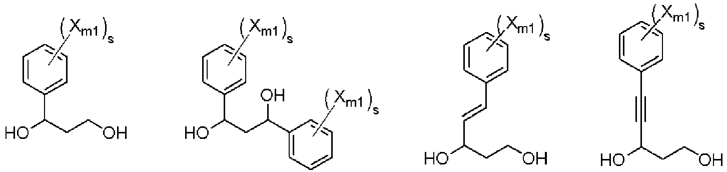

In the formulae, Xₘ₁ and "s" are as defined in the formula (1); the Z in the formulae represents either an oxygen atom or a secondary amine; and any of the hydrogen atoms in the above formulae may be substituted with a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms.

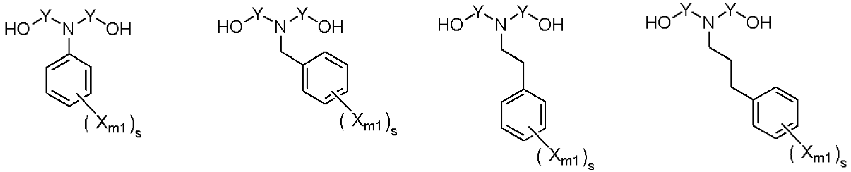

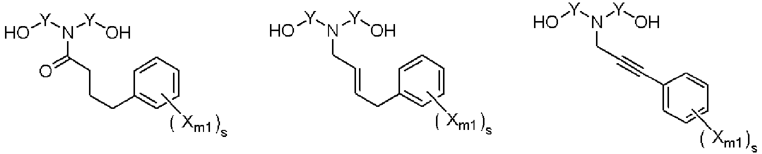

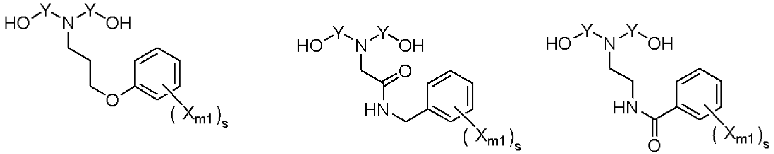

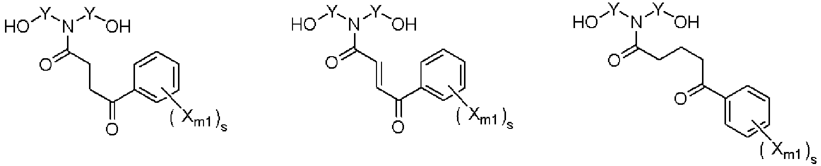

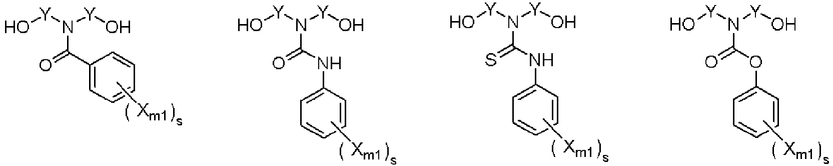

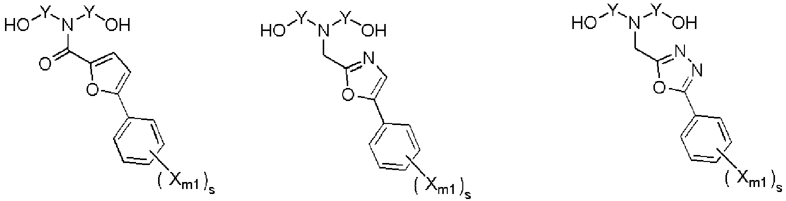

In the formulae, Xₘ₁ and "s" are as defined in the formula (1); Y is as defined in the formula (b-4); and any of the hydrogen atoms in the above formulae may be substituted with a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms.

The compounds represented by the general formulae (b-1) to (b-4) preferably contain one or more chlorine atoms, bromine atoms, or iodine atoms, more preferably a bromine atom or an iodine atom, and further preferably an iodine atom.

Such a compound for forming a metal-containing film contains a chlorine atom, a bromine atom, or an iodine atom, which greatly absorb light, and therefore, a sensitizing effect achieved by secondary electrons generated from the atoms during exposure in EUV lithography can be expected even more.

In particular, an iodine atom has a great atomic weight, and therefore, has a high effect of suppressing acid diffusion from an upper layer resist to a resist underlayer film. Thus, an iodine atom has a characteristic that it can achieve higher sensitivity while maintaining the LWR property that the resist upper layer film originally has, and is therefore preferable.

Furthermore, the inventive compound for forming a metal-containing film preferably further contains a ligand having one or more crosslinkable groups selected from a vinyl group, an allyl group, an allyloxy group, an ethynyl group, a propargyl group, a propargyloxy group, an epoxy group, and an oxetanyl group. More preferably, the compound (b), in particular, the compounds represented by the general formulae (b-1) to (b-4) has at least one of the above-mentioned crosslinkable groups.

When the compound (b) to be used as a ligand, containing a chlorine atom, a bromine atom, or an iodine atom, further contains a crosslinkable group, the heat resistance of the ligand containing the halogen atom is improved, and therefore, when the compound is contained in a composition for forming a metal-containing film, it is possible to form a metal-containing film containing many of the halogen atoms.

It is preferable that the one or more crosslinkable groups selected from a vinyl group, an allyl group, an allyloxy group, an ethynyl group, a propargyl group, a propargyloxy group, an epoxy group, and an oxetanyl group is a monovalent organic group having 2 to 20 carbon atoms and containing a crosslinkable group selected from a vinyl group, an allyl group, an allyloxy group, an ethynyl group, a propargyl group, a propargyloxy group, an epoxy group, and an oxetanyl group, and specifically, contains a structure shown below.

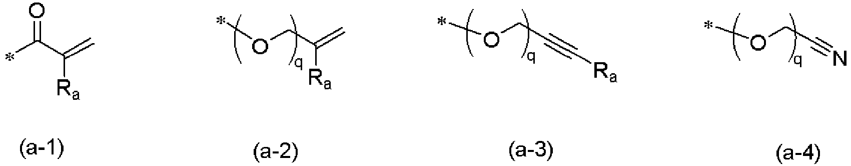

In the general formulae (a-1) to (a-4), Rₐ represents a hydrogen atom or a monovalent organic group having 1 to 10 carbon atoms; "q" represents 0 or 1; and "*" represents an attachment point.

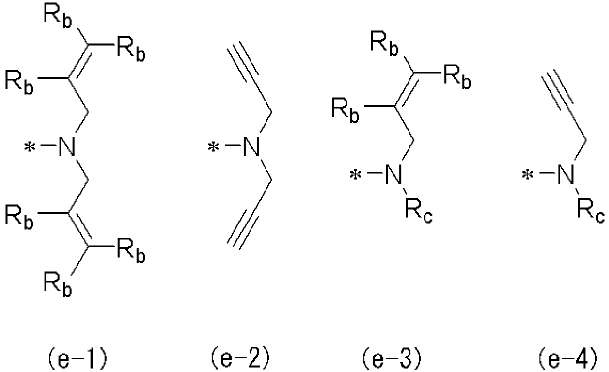

In the general formulae, R_{b}s each represent a hydrogen atom or a methyl group and are identical to or different from each other in a single formula; R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point. 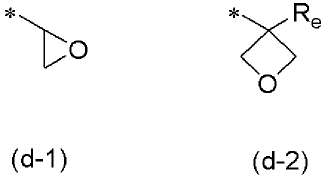 In the formulae, Rₑ represents a hydrogen atom or an organic group having 1 to 10 carbon atoms; and "*" represents an attachment point.

Furthermore, the inventive compound for forming a metal-containing film is preferably a reaction product between: a metal-containing compound (hereinafter, metal-containing compound (a')) containing one or more selected from a metal compound represented by the following formula (3) and a hydrolysis product, condensate, and hydrolysis condensate of the metal compound represented by the following formula (3); and the compound represented by any of the formulae (b-1) to (b-4) .

LₐMX_{b} (3)

In the formula, M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR^{a}R^{b}, R^{a} and R^{b} each independently represent a hydrogen atom or a monovalent organic group having 1 to 20 carbon atoms, and a+b is 2 to 4, "a" and "b" each representing an integer of 0 to 4.

When such a compound for forming a metal-containing film is contained in a composition for forming a metal-containing film, it is possible to form a metal-containing film excellent in dry etching resistance to fluorine gas and oxygen gas.

### [Metal-Containing Compound (a')]

### (Hydrolysable Group)

Examples of the hydrolysable group X of the formula (3) include halogen atoms, alkoxy groups, carboxylate groups, acyloxy groups, and -NR^{a}R^{b}. R^{a} and R^{b} preferably each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR^{a}R^{b} include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### (Monodentate Ligand)

Examples of the monodentate ligand L include a hydroxo ligand, carboxy ligands, amido ligands, amine ligands, an ammonia ligand, olefin ligands, etc.

Examples of the amido ligands include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligands include pyridine, a trimethylamine ligand, a piperidine ligand, etc.

Examples of the olefin ligands include: linear olefins, such as ethylene and propylene; cyclic olefins, such as cyclopentene, cyclohexene, and norbornene; etc.

### (Polydentate Ligand)

Examples of the polydentate ligand L include ligands derived from hydroxy acid esters, ligands derived from β-diketones, ligands derived from β-keto esters, ligands derived from α,α-dicarboxylic acid esters, hydrocarbons having a π bond, diphosphines, etc.

Examples of the hydroxy acid esters include glycolic acid esters, lactic acid esters, 2-hydroxycyclohexane-1-carboxylic acid esters, salicylic acid esters, etc.

Examples of the β-diketones include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid esters include malonic acid diesters, α-alkyl-substituted malonic acid diesters, α-cycloalkyl-substituted malonic acid diesters, α-aryl-substituted malonic acid diesters, etc.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

In the general formula (3), a+b is 2 to 4, and "a" and "b" each represent an integer of 0 to 4. 0 to 4 are favorable as "a", and 2 or 4 is preferable. 0 to 4 are favorable as "b", and 0, 2, or 4 is preferable. By setting "a" and "b" to be within the above ranges, the stability of the inventive compound for forming a metal-containing film can be enhanced.

Preferable examples of the metal compound represented by the formula (3) include the following.

Examples of compounds containing titanium include diisopropoxybis(2,4-pentanedionate)titanium(IV), tetra-n-butoxytitanium(IV), tetra-n-propoxytitanium(IV), tetraisopropoxytitanium(IV), tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV).

Examples of compounds containing zirconium include dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono(2,4-pentanedionate)zirconium(IV), triisopropoxymono(2,4-pentanedionate) zirconium(IV), tri(3-methacryloxypropyl)methoxyzirconium(IV), and tri(3-acryloxypropyl)methoxyzirconium(IV).

Examples of compounds containing hafnium include diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV).

Out of the above examples, metal alkoxide, metal carboxylate, and metal acetate are preferable.

At the time of the synthesis reaction of the compound for forming a metal-containing film, a compound that may become a monodentate ligand or a polydentate ligand (hereinafter, compound (b') for forming a ligand) in the compound for forming a metal-containing film can be contained besides the metal compound (a').

Examples of the compound (b') for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the L in the general formula (3). Examples also include compounds having multiple hydroxy groups etc.

In the inventive compound for forming a metal-containing film, the ligand derived from the structure represented by any of the formulae (b-1) to (b-4) is preferably contained in an amount of 10 mol% to 90 mol%, more preferably 20 mol% to 80 mol%, and further preferably 25 mol% to 75 mol% of the total amount of ligands coordinated to the metal atoms. A ligand other than the ligand of the compound represented by any of the formulae (b-1) to (b-4), for example, a ligand derived from the compound (b') for forming a ligand or an alkoxy group having 1 to 10 carbon atoms is preferably contained in an amount of 0 mol% to 90 mol%, more preferably 20 mol% to 80 mol% of the total amount of ligands coordinated to the metal atoms.

Furthermore, on the occasion of the synthesis reaction of the inventive compound for forming a metal-containing film, a silicon-containing compound (c) may be contained besides the compound (b') for forming a ligand.

By substituting a hydrolysable group of the metal-containing compound (a') with the silicon-containing compound (c), it is possible to enhance the stability of the inventive compound for forming a metal-containing film in the composition for forming a metal-containing film.

Examples of the silicon-containing compound (c) include a structure of the following formula (2).

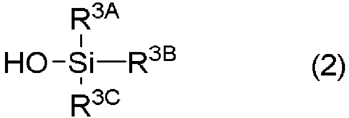

In the general formula (2), R^{3A}, R^{3B}, and R^{3C} each represent any organic group selected from an organic group having 1 to 30 carbon atoms and having any crosslinking group of structures represented by the following general formulae (c-1) to (c-3), a substituted or unsubstituted alkyl group having 1 to 20 carbon atoms, and an aryl group having 1 to 20 carbon atoms.

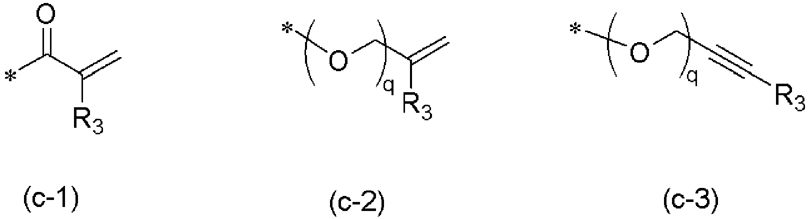

In the general formulae (c-1) to (c-3), R₃ represents a hydrogen atom or a monovalent organic group having 1 to 10 carbon atoms; "q" represents 0 or 1; and "*" represents an attachment point.

The silicon-containing compound is preferably any compound of the following formulae, and from the viewpoint of productivity, trimethylsilanol is more preferable.

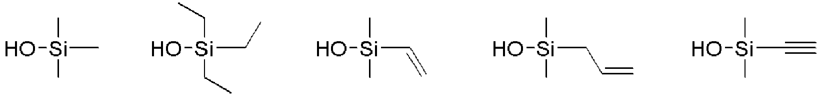

When the inventive compound for forming a metal-containing film contains the ligand derived from any of the structures represented by the formulae (b-1) to (b-4) and the ligand derived from the silicon-containing compound (c), the amount of the ligand derived from any of the structures represented by the formulae (b-1) to (b-4) contained in the inventive compound for forming a metal-containing film is preferably 10 mol% to 100 mol%, more preferably 20 mol% to 80 mol%, and further preferably 25 mol% to 75 mol% of the total amount of ligands coordinated to the metal atoms. The ligand derived from the silicon-containing compound (c) is preferably contained in an amount of 10 mol% to 90 mol%, more preferably 20 mol% to 80 mol%, and further preferably 25 mol% to 75 mol% of the total amount of ligands coordinated to the metal atoms. Ligands other than the ligands of the compound (b') for forming a ligand and the silicon-containing compound (c), for example, a ligand derived from an alkoxy group having 1 to 10 carbon atoms, are preferably contained in an amount of 0 mol% to 90 mol%, more preferably 0 mol% to 75 mol% of the total amount of ligands coordinated to the metal atoms.

The method for synthesizing the inventive compound for forming a metal-containing film is not particularly limited. For example, a metal alkoxide, a metal carboxylate, or a metal acetylacetonate (acac) can be used as the metal-containing compound (a'), and the compound for forming a metal-containing film can be obtained by allowing the alkoxy, carboxy, or acac metal to react with the ligand derived from a compound represented by any of the formulae (b-1) to (b-4). The metal-containing compound (a') may be subjected to hydrolysis condensation and then the product may be allowed to react with the ligand derived from the compound represented by any of the formulae (b-1) to (b-4), or the metal-containing compound (a') may be allowed to react with the ligand derived from the compound represented by any of the formulae (b-1) to (b-4) and then the product may be subjected to hydrolysis condensation. If it is difficult to control the hydrolysis condensation, the reaction with the ligand derived from the compound represented by any of the formulae (b-1) to (b-4) may be performed in a non-hydrous environment. The methods are preferably adjusted appropriately in accordance with the properties required in the inventive compound for forming a metal-containing film and the metal-containing film. When the silicon-containing compound (c) and the compound represented by any of the formulae (b-1) to (b-4) are to be contained as ligands, it is preferable to allow the metal-containing compound (a') and the silicon-containing compound (c) to react and then allow the product to react with the ligand derived from the compound represented by any of the formulae (b-1) to (b-4) .

As a method for performing a hydrolysis condensation reaction using the metal-containing compound (a'), examples include a method of subjecting the metal-containing compound (a') to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the metal-containing compound (a') etc., on the molar basis. The upper limit of the amount of the water is preferably 20-fold, more preferably 15-fold, and further preferably 10-fold on the molar basis.

The solvent used in the synthesis reaction of the inventive compound for forming a metal-containing film is not particularly limited, and for example, a solvent given as an example of the organic solvent (B) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### <Composition for Forming Metal-Containing Film>

The present invention also provides a composition for forming a metal-containing film, the composition functioning as a resist underlayer film material or a resist middle layer film material used in manufacturing a semiconductor, the composition containing: (A) the above-described compound for forming a metal-containing film; and (B) an organic solvent.

### <(A) Compound for Forming Metal-Containing Film>

As the compound (A) for forming a metal-containing film, the inventive compound for forming a metal-containing film described above may be used. The amount of the component (A) to be contained in the composition is not particularly limited, but can be, for example, 1 to 20 parts by mass, preferably 2 to 10 parts by mass based on the total of 100 parts by mass of the components (A) and (B).

### <(B) Organic Solvent>

The organic solvent (B) usable in the inventive composition for forming a metal-containing film is not particularly limited as long as the solvent can dissolve or disperse the above-described compound (A) for forming a metal-containing film, and when contained, a crosslinking agent (C), an acid generator (D), a surfactant (E), a high-boiling-point solvent (B'), other additives, etc., described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts, more preferably 250 to 5,000 parts based on 100 parts by mass of the compound (A) for forming a metal-containing film.

### <(B') High-Boiling-Point Solvent>

In the inventive composition for forming a metal-containing film, the organic solvent (B) may contain a high-boiling-point solvent (B'). The high-boiling-point solvent (B') may be one or more kinds of organic solvent having a boiling point of 180 degrees (°C) or higher.

For example, it is possible to use, as the organic solvent (B), a mixture of one or more kinds of organic solvent having a boiling point of lower than 180°C and one or more kinds of organic solvent having a boiling point of 180°C or higher (high-boiling-point solvent (B')).

The high-boiling-point solvent (B') is not particularly limited to hydrocarbons, alcohols, ketones, esters, ethers, or chlorine-based solvents, as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B') may be selected suitably from the solvents above, for example, depending on the temperature at which the inventive composition for forming a metal-containing film is heat-treated, etc. The boiling point of the high-boiling-point solvent is preferably 180°C to 300°C, further preferably 200°C to 300°C. When the boiling point is as described, there is no risk of excessive evaporation rate at the baking (heating), and therefore, it is possible to suppress the generation of defects induced by dryness at the time of film formation. Moreover, a solvent having such a boiling point does not remain in the film without evaporating even after the baking. Therefore, there is no risk of the solvent adversely affecting the physical properties, such as etching resistance, of the film.

When the high-boiling-point solvent (B') is contained, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### <Other Components>

The above-described composition for forming a metal-containing film is usable for a resist underlayer film or middle layer film used in a multilayer resist method, and contains one or more of each of the compound (A) for forming a metal-containing film and the organic solvent (B), and as necessary, the composition may contain one or more of (C) a crosslinking agent, (D) an acid generator, (E) a surfactant, and (B') a high-boiling-point solvent.

In the following, components that may be contained in the inventive composition for forming a metal-containing film besides the above-described compound (A) for forming a metal-containing film and organic solvent (B) will be described.

### [(C) Crosslinking Agent]

The inventive composition for forming a metal-containing film can also contain a crosslinking agent (C) to increase curability and further inhibit intermixing with a resist upper layer film.

The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents.

One kind of the crosslinking agent (C) can be used, or two or more kinds thereof can be used in combination, and when the crosslinking agent is contained, the contained amount is preferably 5 to 50 parts, more preferably 10 to 40 parts based on 100 parts of the compound (A) for forming a metal-containing film. When the contained amount is 5 parts or more, sufficient curability can be exhibited, and intermixing with a resist upper layer film can be suppressed. Meanwhile, when the contained amount is 50 parts or less, there is no risk of degradation in dry etching resistance due to the proportion of the compound (A) for forming a metal-containing film in the composition being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

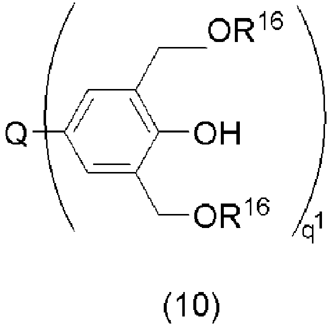

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a hydrocarbon group having a valency of "q¹" and having 1 to 20 carbon atoms. "q¹" represents an integer of 1 to 5, more preferably 2 or 3. Specific examples of Q include groups each of which is obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compound represented by the general formula (10) include the following compounds. In particular, from the viewpoints of enhancing the curability and film thickness uniformity of the adhesive film, hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are preferable.

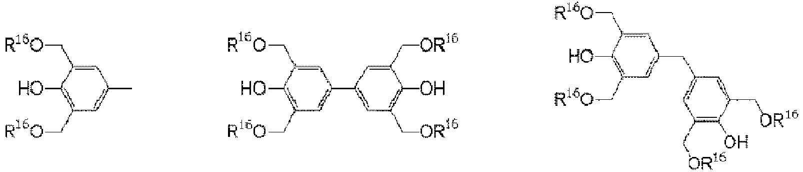

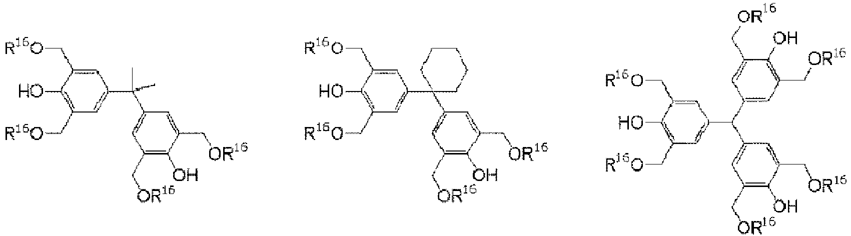

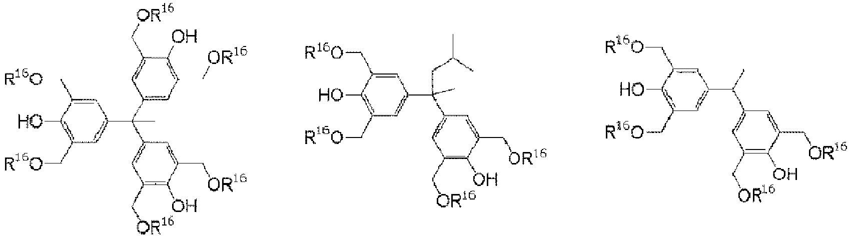

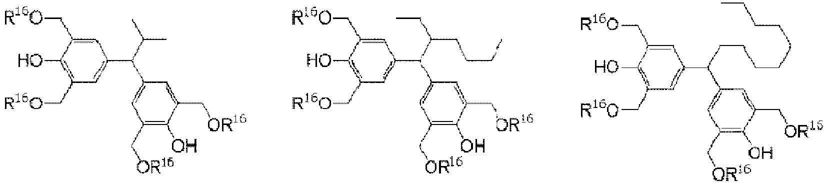

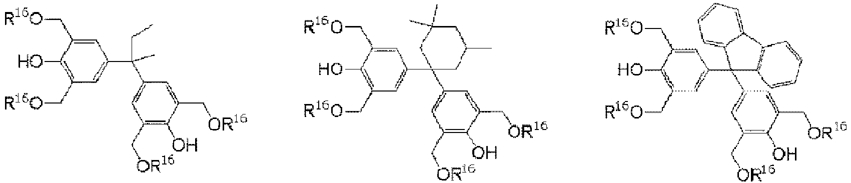

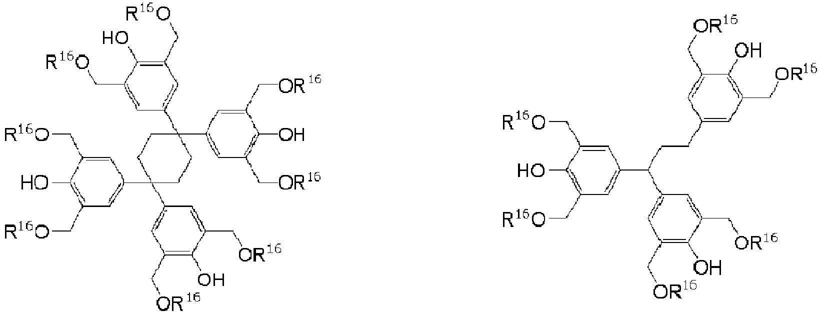

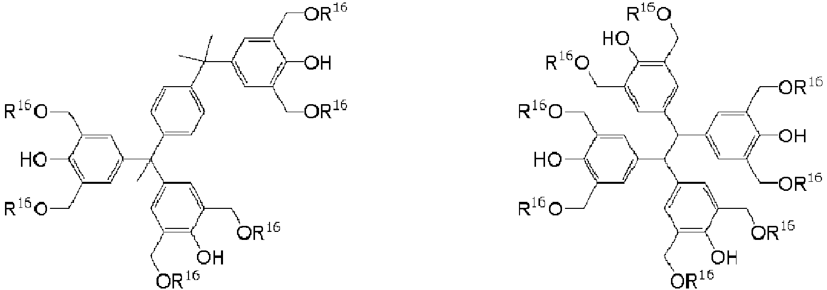

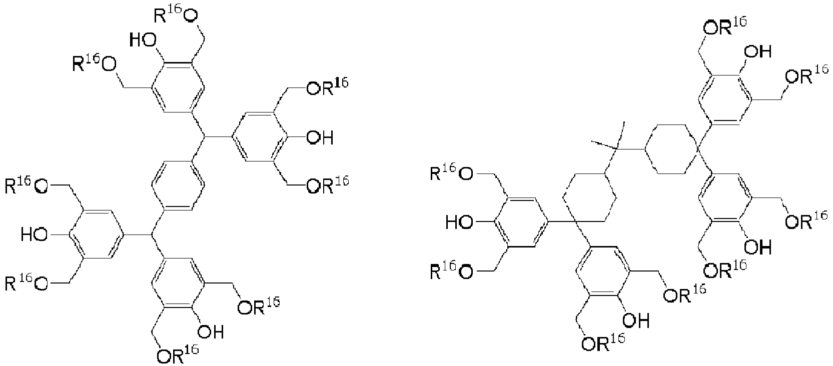

### <(D) Acid Generator>

An acid generator (D) can be contained in the inventive composition for forming a metal-containing film in order to promote further the curing reaction of the compound (A) for forming a metal-containing film. Acid generators can be classified into those that generate an acid by thermal decomposition and those that generate an acid by optical irradiation; however, any acid generator can be contained. Specific examples of the acid generator include the materials disclosed in paragraphs [0061] to [0085] of JP2007-199653A, but are not limited thereto.

One kind of the acid generator can be used, or two or more kinds thereof can be used in combination. When the acid generator is contained, the contained amount is preferably 0.05 to 50 parts, more preferably 0.1 to 10 parts based on 100 parts by mass of the compound (A) for forming a metal-containing film.

### <(E) Surfactant>

A surfactant (E) can be contained in the inventive composition for forming a metal-containing film in order to improve coating property in spin-coating. Examples of the surfactant include those disclosed in [0142] to [0147] of JP2009-269953A. When the surfactant is contained, the contained amount is preferably 0.01 to 10 parts, more preferably 0.05 to 5 parts based on 100 parts by mass of the compound (A) for forming a metal-containing film.

### <Method for Forming Metal-Containing Film>

The present invention provides a method of using the above-described composition for forming a metal-containing film to form a resist underlayer film or middle layer film of a multilayer resist film used in lithography or as a filling film that serves as a planarizing film for manufacturing a semiconductor.

In the method for forming a metal-containing film by using the inventive composition for forming a metal-containing film, a substrate to be processed is coated with the above-described composition for forming a metal-containing film by a spin-coating method or the like. By using a spin-coating method or the like, an excellent filling property can be achieved. After spin-coating, baking (heating) is performed so as to evaporate the solvent and promote a crosslinking reaction to prevent mixing with a resist upper layer film or a resist middle layer film. The baking is preferably performed at a temperature of 100°C or higher and 600°C or lower for 10 to 600 seconds, more preferably at 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a metal-containing film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By virtue of baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Metal-Containing Film>

Next, patterning processes using the inventive composition for forming a metal-containing film will be described.

### <Two-Layer Resist Process>

The present invention provides, as a patterning process according to a two-layer resist process using the above-described composition for forming a metal-containing film, a patterning process including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

To ensure adhesiveness to the resist upper layer film, an adhesive film may be formed between the resist upper layer film and the metal-containing film of the present invention. As the adhesive film, it is possible to use an organic film or a silicon-containing film containing polysiloxane.

A patterning process according to a resist process using the inventive composition for forming a metal-containing film is useful for enhancing the exposure sensitivity of a resist upper layer film, and therefore, it is preferable to use the composition for an underlayer film that is at a short distance from the resist upper layer film, and it is more preferable to use the composition directly under the resist upper layer film. When an adhesive film is used between the resist upper layer film and the metal-containing film, the adhesive film preferably has a film thickness of 20 nm or less, more preferably 15 nm or less, and further preferably 10 nm or less. The thinner the adhesive film, the greater the proportion of the contribution of the metal-containing film to the improvement of the exposure sensitivity of the resist upper layer film, which is preferable.

### <Three-Layer Resist Process>

The present invention also provides, as a patterning process according to a three-layer resist process using the above-described composition for forming a metal-containing film, a patterning process including the steps of:
(II-1) forming an organic resist underlayer film on a substrate to be processed;
(II-2) applying the above-described composition for forming a metal-containing film onto the organic resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed.

The patterning process according to the three-layer resist process of the present invention will be described with reference to FIG. 1. Firstly, an organic resist underlayer film 2 is formed on a substrate 1 to be processed (I-A), then a metal-containing film 3 is formed as a resist middle layer film by using the inventive composition for forming a metal-containing film (I-B), and a resist upper layer film 4 is formed thereon by using a photoresist material (I-C). Subsequently, the resist upper layer film 4 is subjected to exposure P while using a mask 5 (I-D), and post-exposure baking (PEB) is performed (I-E). Subsequently, development is performed to form a resist upper layer film pattern 4a (I-F). Subsequently, the metal-containing film 3 is dry-etched while using the resist upper layer film pattern 4a as a mask to form a metal-containing film pattern 3a (I-G). Subsequently, the resist upper layer film pattern 4a is removed, and then the organic resist underlayer film 2 is dry-etched while using the metal-containing film pattern 3a as a mask to form an organic resist underlayer film pattern 2a (I-H). Furthermore, the metal-containing film pattern 3a is removed, and then the substrate 1 to be processed is etched while using the organic resist underlayer film pattern 2a as a mask to form a pattern 1a (I-I).

The metal-containing film in the three-layer resist process described above exhibits etching resistance with respect to oxygen-based gas. Therefore, the dry etching of the organic resist underlayer film that is performed while using the metal-containing film as a mask in the three-layer resist process is preferably performed using an etching gas mainly containing an oxygen-based gas.

As the organic resist underlayer film material that can be used for the organic resist underlayer film, it is possible to use: materials already known as materials for an underlayer film for three-layer resist methods or two-layer resist methods using a silicon resist composition; 4,4'-(9-fluorenylidene) bisphenol novolak resin (molecular weight: 11,000) disclosed in JP2005-128509A; and also many resins including novolak resins, known as resist underlayer film materials for two-layer resist methods and three-layer resist methods. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic resist underlayer film can be formed on the substrate to be processed by using a composition solution and by a spin-coating method or the like in the same manner as the photoresist composition. After forming the organic resist underlayer film by a spin-coating method or the like, it is desirable to bake the film in order to evaporate the organic solvent. The baking temperature is preferably 80 to 400°C, and the baking time is preferably 10 to 300 seconds.

Instead of the organic resist underlayer film, it is also possible to adopt an organic hard mask formed by a CVD method or an ALD method.

Furthermore, in the present invention, the patterning process according to the three-layer resist process using the above-described composition for forming a metal-containing film may be a patterning process including:
forming a metal-containing film on a substrate to be processed by using the above-described composition for forming a metal-containing film;
forming an inorganic hard mask middle layer film selected from a silicon-containing resist middle layer film, a silicon oxide film, a silicon nitride film, and a silicon oxynitride film on the metal-containing film;
forming a resist upper layer film on the inorganic hard mask by using a photoresist material;
subjecting the resist upper layer film to pattern exposure and then development with a developer to form a pattern in the resist upper layer film;
transferring the pattern to the inorganic hard mask middle layer film by dry etching while using the resist upper layer film having the formed pattern as a mask;
transferring the pattern to the metal-containing film by dry etching while using the inorganic hard mask middle layer film having the transferred pattern as a mask; and
processing the substrate to be processed while using the metal-containing film having the formed pattern as a mask to form the pattern in the substrate to be processed.

### <Four-Layer Resist Process>

In addition, the present invention also provides, as a patterning process according to a four-layer resist process using the above-described composition for forming a metal-containing film, a patterning process including the steps of:
(III-1) applying the above-described composition for forming a metal-containing film onto a substrate to be processed, followed by heating to form a metal-containing film;
(III-2) forming an inorganic hard mask middle layer film selected from a silicon-containing resist middle layer film, a silicon oxide film, a silicon nitride film, and a silicon oxynitride film on the metal-containing film;
(III-3) forming an organic thin film (e.g. organic antireflective film (BARC) or an adhesive film) on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

In this event, the inorganic hard mask middle layer film is preferably formed by a CVD method or an ALD method.

When the inorganic hard mask is formed by a CVD method or an ALD method, a fine pattern can be formed on a body to be processed with higher accuracy.

When a silicon-containing resist middle layer film is used as the inorganic hard mask middle layer film in the above-described patterning process, a polysiloxane-based middle layer film is also favorably used as the silicon-containing resist middle layer film. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is to be cross-linked by an acid or heat.

As the inorganic hard mask middle layer film, an inorganic hard mask may be formed. In this case, a semiconductor device circuit pattern can be formed in a substrate, at least, by:
forming a metal-containing film on a body to be processed by using the inventive composition for forming a metal-containing film;
forming an inorganic hard mask selected from a silicon oxide film, a silicon nitride film, and a silicon oxynitride film on the metal-containing film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the metal-containing film while using the inorganic hard mask having the formed pattern as a mask; and
furthermore, etching the body to be processed while using the metal-containing film having the formed pattern as a mask to form the pattern in the body to be processed.

As described above, when the inorganic hard mask is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300°C to 500°C. Thus, the metal-containing film formed by spin-coating and the inorganic hard mask formed by the CVD method or the ALD method can be combined.

As described above, a photoresist film may be formed on the inorganic hard mask as the resist upper layer film. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the photoresist composition is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6000 mTorr. Precursor liquid flow rates for metal-oxide-containing film (e.g., an organotin oxide precursor) can be 0.01 to 10 cmm, and gas flow rates (CO₂, CO, Ar, and N₂) can be 100 to 10000 sccm. Plasma powers can be 200 to 1000 W per 300 mm wafer station, using a highfrequency plasma (e.g., 13.56 MHz, 27.1 MHz, or higher). Deposited thickness is preferably 100 to 2000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is possible to use a patterning process using a photolithography with a wavelength of 5 nm or more and 300 nm or less, a direct drawing using an electron beam, nanoimprinting, or a combination thereof. In the present invention, EUV light is the most preferable.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the metal-containing film is etched while using the obtained silicon-containing resist middle layer film pattern or inorganic hard mask pattern as a mask. The etching of the metal-containing film is preferably performed using an etching gas mainly containing a chlorine-based gas.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which a layer to be processed is formed on the substrate, and the like. Examples of the layer to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

### <Multilayer Resist Process>

Furthermore, the present invention also provides, as a patterning process according to a multilayer resist process using the above-described composition for forming a metal-containing film, a patterning process including the steps of:
(IV-1) applying the above-described composition for forming a metal-containing film onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed.

Examples of patterning processes according to a multilayer resist process using the above-described composition for forming a metal-containing film include a patterning process including the steps of:
forming a metal-containing film on a substrate to be processed by using the above-described composition for forming a metal-containing film;
forming an organic middle layer film on the metal-containing film by using an organic resist underlayer film material;
forming a silicon-containing resist middle layer film on the organic middle layer film by using a silicon-containing resist middle layer film material;
forming an organic antireflective film (BARC) or an adhesive film on the silicon-containing resist middle layer film as necessary;
forming a resist upper layer film on the silicon-containing resist middle layer film, on the BARC, or on the adhesive film by using a photoresist material;
subjecting the resist upper layer film to pattern exposure and then development with a developer to form a pattern in the resist upper layer film;
transferring the pattern to the BARC or the adhesive film and the silicon-containing resist middle layer film by dry etching while using the resist upper layer film having the formed pattern as a mask;
transferring the pattern to the organic middle layer film by dry etching while using the silicon-containing resist middle layer film having the transferred pattern as a mask;
transferring the pattern to the metal-containing film while using the organic middle layer film as a mask; and
processing the substrate to be processed while using the metal-containing film having the formed pattern as a mask to form the pattern in the substrate to be processed.

As the organic resist underlayer film material that can be used for the organic middle layer film, it is possible to use: materials already known as materials for an underlayer film for three-layer resist methods or two-layer resist methods using a silicon resist composition; 4,4'-(9-fluorenylidene) bisphenol novolak resin (molecular weight: 11,000) disclosed in JP2005-128509A; and also many resins including novolak resins, known as resist underlayer film materials for two-layer resist methods and three-layer resist methods. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic middle layer film can be formed on the substrate to be processed by using a composition solution and by a spin-coating method or the like in the same manner as the photoresist composition. After forming the organic underlayer film by a spin-coating method or the like, it is desirable to bake the film in order to evaporate the organic solvent. The baking temperature is preferably 80 to 400°C, and the baking time is preferably 10 to 300 seconds.

Instead of the organic resist underlayer film material, it is also possible to adopt an organic hard mask formed by a CVD method or an ALD method.

The organic middle layer film in the multilayer resist process described above exhibits etching resistance with respect to chlorine-based gas. Therefore, the dry etching of the metal-containing film that is performed while using the organic middle layer film as a mask in the multilayer resist process is preferably performed using an etching gas mainly containing a chlorine-based gas.

### EXAMPLES

The present invention is more specifically described below with reference to Synthesis Examples, Examples, and Comparative Examples. However, the present invention is not limited to these Examples.

### [Synthesis of Compounds (A-1) to (A-19) for Forming Metal-Containing Film]

In the following Synthesis Examples, the following organic group starting material group G ((G1) to (G14)) and silicon-containing organic group starting material group H ((H1) and (H2)) were used.

The starting material group G ((G1) to (G14)) is shown below.

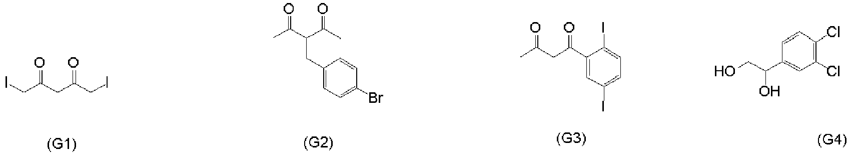

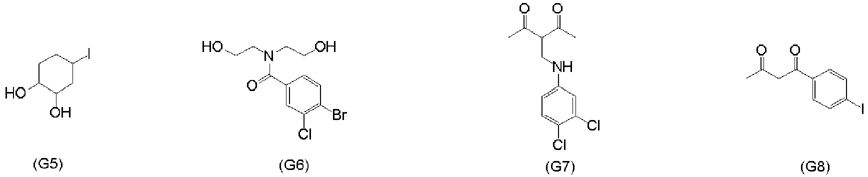

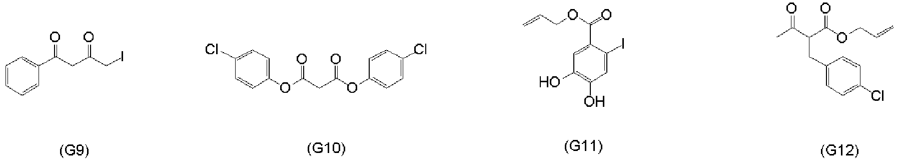

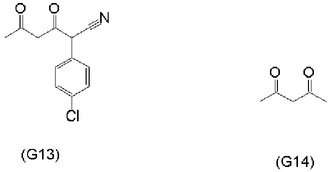

The starting material group H ((H1) and (H2)) is shown below.

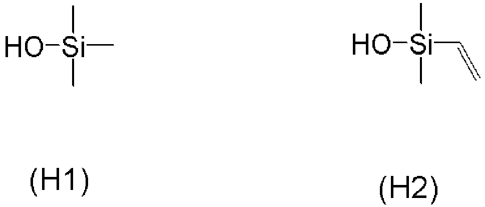

As a metal source M, the following metal compounds were used.
(M1): hafnium(IV) n-butoxide
(M2): titanium tetraisopropoxide
(M3): zirconium(IV) tetrabutoxide (80 wt% solution in 1-butanol)

### [Synthesis Example 1] Synthesis of Compound (A-1) for Forming Metal-Containing Film

Under a nitrogen atmosphere, 23.5 g of hafnium(IV) n-butoxide (M1) was dissolved in 25.5 g of a PGMEA/PGME (ratio by weight: 70/30) solution, and while stirring, the reaction temperature was set to 60°C, and stirring was continued for 2 hours. Subsequently, a mixture obtained by suspending 17.6 g of the compound G1 in 35.0 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-1) for forming a metal-containing film in PGMEA/PGME was obtained. The concentration of the components in the solution other than the solvent was 24% by mass.

### [Synthesis Examples 2 to 16] Synthesis of Compounds (A-2) to (A-15) and Comparative Compound (R-1)

The compounds (A-2) to (A-15) and comparative compound (R-1) shown in Table 1 were obtained under the same reaction conditions as in Synthesis Example 1, except that the metal source M and the compound group G were used at the charging amounts shown in Table 1.

**[Table 1]**

| Synthesis Example | Metal compound | | Organic ligand | | Silicon-containing ligand | | Compound for forming metal-containing film |
|---|---|---|---|---|---|---|---|
| | Symbol | Parts by mass | Composition | Parts by mass | Composition | Parts by mass | |
| 1 | M1 | 23.5 | G1 | 17.6 | None | | A-1 |
| 2 | M1 | 23.5 | G2 | 13.4 | None | | A-2 |
| 3 | M1 | 23.5 | G3 | 20.7 | None | | A-3 |
| 4 | M1 | 23.5 | G4 | 10.3 | None | | A-4 |
| 5 | M1 | 23.5 | G5 | 12.1 | None | | A-5 |
| 6 | M1 | 23.5 | G6 | 16.1 | None | | A-6 |
| 7 | M1 | 23.5 | G7 | 13.7 | None | | A-7 |
| 8 | M1 | 23.5 | G8 | 14.4 | None | | A-8 |
| 9 | M1 | 23.5 | G9 | 14.4 | None | | A-9 |
| 10 | M1 | 23.5 | G10 | 16.2 | None | | A-10 |
| 11 | M1 | 23.5 | G11 | 16.0 | None | | A-11 |
| 12 | M1 | 23.5 | G12 | 13.3 | None | | A-12 |
| 13 | M1 | 23.5 | G13 | 11.8 | None | | A-13 |
| 14 | M2 | 14.2 | G8 | 14.4 | None | | A-14 |
| 15 | M3 | 24.0 | G8 | 14.4 | None | | A-15 |
| 16 | M1 | 23.5 | G14 | 5.0 | None | | Comparative R-1 |

### [Synthesis Example 17] Synthesis of Compound (A-16) for Forming Metal-Containing Film

Under a nitrogen atmosphere, 23.5 g of hafnium(IV) n-butoxide (M1) was dissolved in 25.5 g of a PGMEA/PGME (ratio by weight: 70/30) solution, and while stirring, the reaction temperature was raised to 50°C, and 9.0 g of the compound H1 was added dropwise to the solution. After the addition, the reaction temperature was set to 60°C, and stirring was continued for 2 hours. Subsequently, a mixture obtained by suspending 14.4 g of the compound G8 in 22.0 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-16) for forming a metal-containing film in PGMEA/PGME was obtained. The concentration of the components in the solution other than the solvent was 22% by mass.

### [Synthesis Example 18] Synthesis of Compound (A-17)

The compound (A-17) shown in Table 2 was obtained under the same reaction conditions as in Synthesis Example 17, except that the metal source M, the compound group G, and the compound group H were used at the charging amounts shown in Table 2.

**[Table 2]**

| Synthesis Example | Metal compound | | Organic ligand | | Silicon-containing ligand | | Compound for forming metal-containing film |
|---|---|---|---|---|---|---|---|
| | Symbol | Parts by mass | Composition | Parts by mass | Composition | Parts by mass | |
| 17 | M1 | 23.5 | G8 | 14.4 | H1 | 9.0 | A-16 |
| 18 | M1 | 23.5 | G8 | 14.4 | H2 | 10.2 | A-17 |

### [Synthesis Example 19] Synthesis of Compound (A-18) for Forming Metal-Containing Film

Under a nitrogen atmosphere, into a solution of 23.5 g of hafnium(IV) n-butoxide (M1) in 20.5 g of n-butanol, while stirring, a solution of 0.68 g of deionized water in 27.5 g of n-butanol was added dropwise at room temperature over 2 hours. To the obtained solution, 14.4 g of the compound (G8) was added, and the mixture was agitated at room temperature for 30 minutes. After the solution was concentrated under reduced pressure at 30°C, it was further heated to 60°C and heating was continued under reduced pressure to generate no distillate. When a distillate was no longer observed, 45.0 g of a PGMEA/PGME (ratio by weight: 70/30) solution was added thereto and heated under reduced pressure at 40°C to obtain a solution of a compound (A-18) for forming a metal-containing film in PGMEA/PGME. The concentration of the components in the solution other than the solvent was 21% by mass.

### [Synthesis Example 20] Synthesis of Compound (A-19)

The compound (A-19) shown in Table 3 was obtained under the same reaction conditions as in Synthesis Example 19, except that the metal source M and the compound group G were used at the charging amounts shown in Table 3.

**[Table 3]**

| Synthesis Example | Metal compound | | Organic ligand | | Compound for forming metal-containing film |
|---|---|---|---|---|---|
| | Symbol | Parts by mass | Composition | Parts by mass | |
| 19 | M1 | 23.5 | G8 | 14.4 | A-18 |
| 20 | M1 | 23.5 | G11 | 16.0 | A-19 |

### [Preparation of Compositions for Forming Metal-Containing Film]

Crosslinking agents and an acid generator used for the preparation of compositions for forming a metal-containing film are shown below.

### [Crosslinking Agents (XL-1) and (XL-2)]

Crosslinking agents (XL-1) and (XL-2), used in compositions for forming a metal-containing film, are shown below.

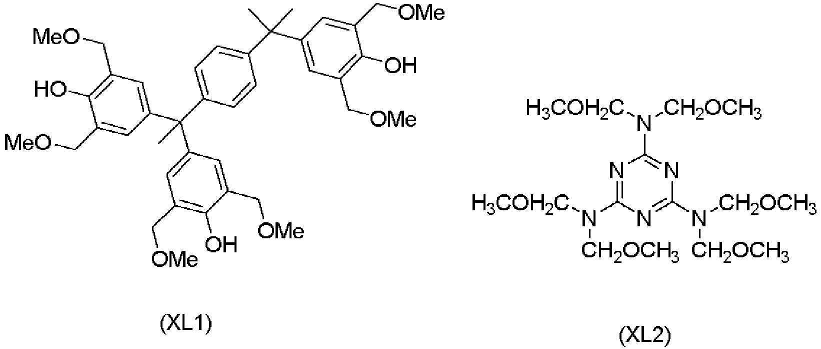

### [Acid Generator (D-1)]

An acid generator (D-1), used in a composition for forming a metal-containing film, is shown below.

(CH₃CH₂)₃N⁺H C₄F₉SO₃⁻ (D1)

### [Preparation Example 1] Preparation of Composition (UDL-1) for Forming Metal-Containing Film

The compound (A-1) for forming a metal-containing film was dissolved in a mixed solvent of propylene glycol monomethyl ether acetate (PGMEA) and propylene glycol monomethyl ether (PGME) in the proportion shown in Table 4, and the solution was filtered through a 0.02-µm membrane filter to prepare a composition (UDL-1) for forming a metal-containing film.

### [Preparation Examples 2 to 23] Preparation of Compositions (UDL-2 to -22) for Forming Metal-Containing Film and Composition (Comparative UDL-1) for Forming Metal-Containing Film for Comparative Example

Each chemical liquid was prepared in the same manner as UDL-1, except that the type and the contained amount of each component were as shown in Table 4. In Table 4, "-" indicates that the component was not used. As a high-boiling-point solvent (F-1), ethylene glycol dibenzyl ether (boiling point: 364°C) was used.

**[Table 4]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (5) | - | PGMEA/PGME (75/20) |
| UDL-2 | A-2 (5) | - | PGMEA/PGME (75/20) |
| UDL-3 | A-3 (5) | - | PGMEA/PGME (75/20) |
| UDL-4 | A-4 (5) | - | PGMEA/PGME (75/20) |
| UDL-5 | A-5 (5) | - | PGMEA/PGME (75/20) |
| UDL-6 | A-6 (5) | - | PGMEA/PGME (75/20) |
| UDL-7 | A-7 (5) | - | PGMEA/PGME (75/20) |
| UDL-8 | A-8 (5) | - | PGMEA/PGME (75/20) |
| UDL-9 | A-9 (5) | - | PGMEA/PGME (75/20) |
| UDL-10 | A-10 (5) | - | PGMEA/PGME (75/20) |
| UDL-11 | A-11 (5) | - | PGMEA/PGME (75/20) |
| UDL-12 | A-12 (5) | - | PGMEA/PGME (75/20) |
| UDL-13 | A-13 (5) | - | PGMEA/PGME (75/20) |
| UDL-14 | A-14 (5) | - | PGMEA/PGME (75/20) |
| UDL-15 | A-15 (5) | - | PGMEA/PGME (75/20) |
| UDL-16 | A-16 (5) | - | PGMEA/PGME (75/20) |
| UDL-17 | A-17 (5) | - | PGMEA/PGME (75/20) |
| UDL-18 | A-18 (5) | - | PGMEA/PGME (75/20) |
| UDL-19 | A-19 (5) | - | PGMEA/PGME (75/20) |
| UDL-20 | A-8 (5) | F-1 (5) | PGMEA/PGME (75/20) |
| UDL-21 | A-8 (5) | XL-1 (2) | PGMEA/PGME (75/20) |
| UDL-22 | A-8 (5) | XL-2 (2) | PGMEA/PGME (75/20) |
| | | D-1 (0.2) | |
| Comparative UDL-1 | R-1 (5) | - | PGMEA/PGME (75/20) |

### [Examples 1-1 to 1-22 and Comparative Example 1-1] Patterning Test

On a silicon wafer, an organic underlayer film (ODL-301 manufactured by Shin-Etsu Chemical Co., Ltd.) was formed using a coating-type organic underlayer film material to obtain a Si substrate. Subsequently, each of the compositions UDL-1 to -22 and comparative UDL-1 for forming a metal-containing film prepared above were respectively applied onto the Si substrate by spin-coating and heated at 250°C for 60 seconds to prepare a 20-nm thick metal-containing film.

Subsequently, a resist material obtained by dissolving the following components in the proportion of Table 5 was applied to the metal-containing film by spin-coating and prebaked using a hot plate at 105°C for 60 seconds to prepare a resist film having a film thickness of 60 nm. The resist film was exposed using an EUV scanner NXE3300 (manufactured by ASML, NA: 0.33, σ: 0.9/0.6, quadrupole illumination, with a mask having a hole pattern with a pitch of 46 nm and +20% bias (on-wafer size)), followed by PEB on a hot plate at 100°C for 60 seconds and development with a 2.38 mass% aqueous solution of TMAH for 30 seconds to obtain a hole pattern with a size of 23 nm.

Using CD-SEM (CG5000) manufactured by Hitachi High-Technologies Corp., an exposure dose at which the hole dimension of 23 nm was formed was measured and determined as sensitivity. In addition, the dimensions of 50 holes in this event were measured, and dimensional variation (CDU, 3σ) was calculated. The results are shown in Table 6.

### Polymer:

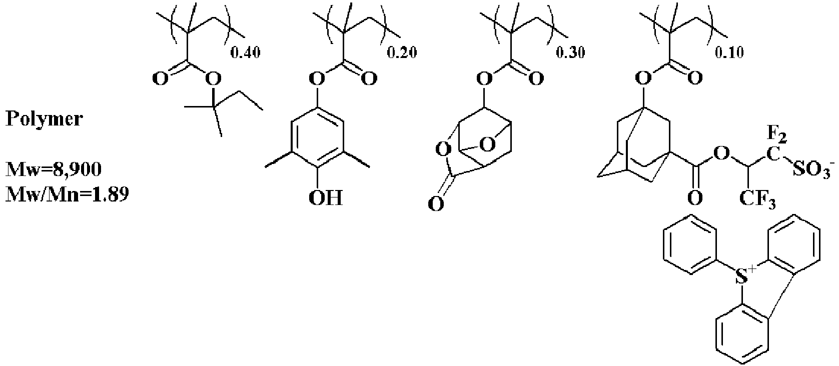

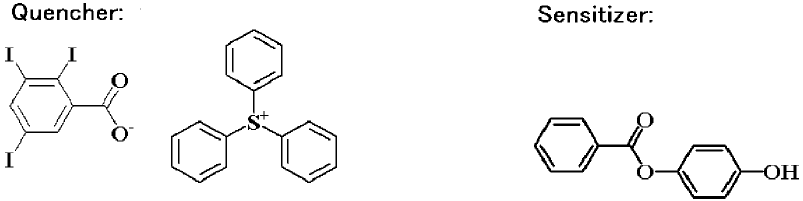

Surfactant: FC-4430 available from 3M

**[Table 5]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

| | | | | | |
|---|---|---|---|---|---|
| · Organic solvents: PGMEA (propylene glycol monomethyl ether acetate) CyHO (cyclohexanone) PGME (propylene glycol monomethyl ether) | | | | | |

**[Table 6]**

| Example | Composition for forming metal-containing film | Baking temperature (°C) | Patterning test | |
|---|---|---|---|---|
| | | | Sensitivity (mJ/cm² ) | CDU (nm) |
| Example 1-1 | UDL-1 | 250°C | 24 | 3.4 |
| Example 1-2 | UDL-2 | 250°C | 26 | 3.3 |
| Example 1-3 | UDL-3 | 250°C | 22 | 3.4 |
| Example 1-4 | UDL-4 | 250°C | 25 | 3.3 |
| Example 1-5 | UDL-5 | 250°C | 24 | 3.5 |
| Example 1-6 | UDL-6 | 250°C | 24 | 3.3 |
| Example 1-7 | UDL-7 | 250°C | 25 | 3.4 |
| Example 1-8 | UDL-8 | 250°C | 23 | 3.4 |
| Example 1-9 | UDL-9 | 250°C | 24 | 3.5 |
| Example 1-10 | UDL-10 | 250°C | 25 | 3.3 |
| Example 1-11 | UDL-11 | 250°C | 21 | 3.1 |
| Example 1-12 | UDL-12 | 250°C | 23 | 3.3 |
| Example 1-13 | UDL-13 | 250°C | 24 | 3.2 |
| Example 1-14 | UDL-14 | 250°C | 25 | 3.3 |
| Example 1-15 | UDL-15 | 250°C | 27 | 3.2 |
| Example 1-16 | UDL-16 | 250°C | 23 | 3.3 |
| Example 1-17 | UDL-17 | 250°C | 23 | 3.4 |
| Example 1-18 | UDL-18 | 250°C | 22 | 3.4 |
| Example 1-19 | UDL-19 | 250°C | 19 | 3.2 |
| Example 1-20 | UDL-20 | 250°C | 23 | 3.4 |
| Example 1-21 | UDL-21 | 250°C | 23 | 3.3 |
| Example 1-22 | UDL-22 | 250°C | 22 | 3.3 |
| Comparative Example 1-1 | Comparative UDL-1 | 250°C | 32 | 3.6 |

From the results shown in Table 6, it can be observed that a pattern can be formed with high sensitivity and without the degradation of CDU when using, as a resist middle layer film, a metal-containing film formed using a composition for forming a metal-containing film containing the inventive compound for forming a metal-containing film, the metal-containing film containing a ligand substituted with a halogen atom selected from any of a chlorine atom, a bromine atom, and an iodine atom (Examples 1-1 to 1-22). From these results, it can be seen that the resist middle layer film can contribute to the enhancement of sensitivity while maintaining the LWR of the upper layer resist.

When the metal atom is fixed as hafnium to compare the effect of the ligand on the sensitivity of the resist upper layer film, sensitivity was excellent in the Examples using the metal compounds containing an iodine atom, out of a chlorine atom, a bromine atom, and an iodine atom, the sensitivity was better in the Examples using the metal compounds containing, as a ligand, an aromatic ring substituted with an iodine atom (Examples 1-3 and 1-8), and the sensitivity was even better in the Example using the metal compounds containing, as a ligand, an aromatic ring substituted with an organic group containing an iodine atom and a crosslinking group (Example 1-11). This is conjectured to be because an iodine atom, which greatly absorbs light, was contained in addition to a metal atom, which greatly absorbs light, and an aromatic ring substituted with an organic group containing a crosslinking group was contained, so that it was possible to form a metal-containing film excellent in heat resistance, and an excellent sensitizing effect was exhibited by virtue of secondary electrons generated from the atoms during exposure in EUV lithography.

On the other hand, sensitivity was poor in the case using a resist middle layer film formed using a composition for forming a metal-containing film containing a compound for forming a metal-containing film not containing any of a chlorine atom, a bromine atom, or an iodine atom in the ligand (Comparative Example 1-1).

As described above, the present invention can break the trade-off relationship between sensitivity and LWR and makes it possible to form a resist underlayer film or middle layer film that can contribute to the improvement of sensitivity while maintaining the LWR of the upper layer resist, and therefore, has a high utility value in the field of EUV lithography.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

The present description includes the following embodiments.
[1]: A compound for forming a metal-containing film, comprising:
   at least one kind of metal atom (a) selected from the group consisting of Ti, Zr, and Hf; and a polydentate ligand coordinated to the metal atom (a),
   wherein the polydentate ligand is derived from a compound (b) having 1 to 50 carbon atoms and being substituted with at least one kind of halogen atom selected from the group consisting of a chlorine atom, a bromine atom, and an iodine atom.
[2]: The compound for forming a metal-containing film of [1], wherein the compound (b) contains any of structures represented by the following general formulae (b-1) to (b-4), 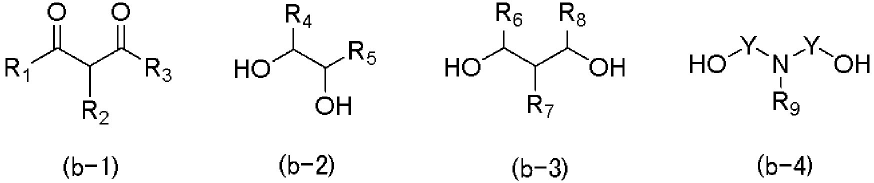 wherein R₁ to R₃ each represent a hydrogen atom or a monovalent organic group having 1 to 30 carbon atoms and optionally containing any of a chlorine atom, a bromine atom, and an iodine atom; R₄ and R₅ each represent a hydrogen atom or a monovalent organic group having 1 to 30 carbon atoms and optionally containing any of a chlorine atom, a bromine atom, and an iodine atom; R₆ to R₉ each represent a hydrogen atom or a monovalent organic group having 1 to 30 carbon atoms and optionally containing any of a chlorine atom, a bromine atom, and an iodine atom; Y represents a divalent organic group having 1 to 10 carbon atoms; the R₄ and the R₅ in the general formula (b-2), being adjacent to each other, are optionally bonded to each other to form an unsaturated or saturated cyclic structure; and compounds of the general formulae (b-1) to (b-4) contain at least one of any of a chlorine atom, a bromine atom, and an iodine atom.
[3]: The compound for forming a metal-containing film of [2], wherein the compounds represented by the general formulae (b-1) to (b-4) contain at least one of an aromatic ring, a heteroaromatic ring, and an alicyclic structure.
[4]: The compound for forming a metal-containing film of [2] or [3], wherein the compound represented by the general formulae (b-1) to (b-4) contains a structure represented by the following formula (1), 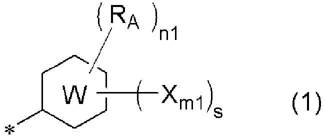 wherein Xₘ₁ represents any of a chlorine atom, a bromine atom, and an iodine atom, or a monovalent organic group having 1 to 10 carbon atoms and containing any of a chlorine atom, a bromine atom, and an iodine atom; W represents an organic group having 5 to 20 carbon atoms and containing any of an aromatic ring, a heteroaromatic ring, and an alicyclic structure; R_{A} is selected from a linear alkyl group having 1 to 10 carbon atoms, a branched alkyl group having 1 to 10 carbon atoms, an alkoxy group having 1 to 10 carbon atoms, a hydroxy group, a halogen atom, and a halogenated alkyl group having 1 to 10 carbon atoms; "s" is 1 to 5; and "n₁" is 0 to 2.
[5]: The compound for forming a metal-containing film of any one of [1] to [4], further comprising a ligand (c) derived from a silicon compound represented by the following general formula (2), 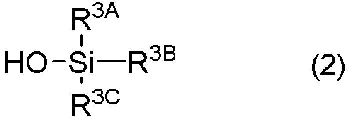 wherein R^{3A}, R^{3B}, and R^{3C} each represent any organic group selected from an organic group having 1 to 30 carbon atoms and having any crosslinking group of structures represented by the following general formulae (c-1) to (c-3), a substituted or unsubstituted alkyl group having 1 to 20 carbon atoms, and an aryl group having 1 to 20 carbon atoms, 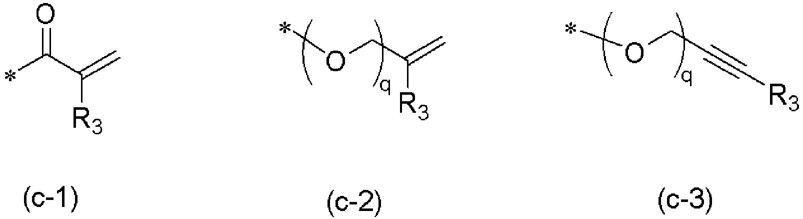 wherein R₃ represents a hydrogen atom or a monovalent organic group having 1 to 10 carbon atoms; "q" represents 0 or 1; and "*" represents an attachment point.
[6]: The compound for forming a metal-containing film of any one of [1] to [5], further comprising a ligand having one or more crosslinkable groups selected from a vinyl group, an allyl group, an allyloxy group, an ethynyl group, a propargyl group, a propargyloxy group, an epoxy group, and an oxetanyl group.
[7]: The compound for forming a metal-containing film of any one of [1] to [6], wherein the compound (b) further has one or more crosslinkable groups selected from a vinyl group, an allyl group, an allyloxy group, an ethynyl group, a propargyl group, a propargyloxy group, an epoxy group, and an oxetanyl group.
[8]: The compound for forming a metal-containing film of [2], being a reaction product between: a metal-containing compound containing one or more selected from a metal compound represented by the following formula (3) and a hydrolysis product, condensate, and hydrolysis condensate of the metal compound represented by the following formula (3); and the compound represented by any of the formulae (b-1) to (b-4),

   LₐMX_{b} (3)

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR^{a}R^{b}, R^{a} and R^{b} each independently represent a hydrogen atom or a monovalent organic group having 1 to 20 carbon atoms, and a+b is 2 to 4, "a" and "b" each representing an integer of 0 to 4.
[9]: The compound for forming a metal-containing film of any one of [1] to [8], wherein the compound (b) contains one or more chlorine atoms.
[10]: The compound for forming a metal-containing film of any one of [1] to [9], wherein the compound (b) contains one or more bromine atoms.
[11]: The compound for forming a metal-containing film of any one of [1] to [10], wherein the compound (b) contains one or more iodine atoms.
[12]: A composition for forming a metal-containing film, the composition functioning as a resist underlayer film material or a resist middle layer film material used in manufacturing a semiconductor, the composition comprising:
   (A) the compound for forming a metal-containing film any one of [1] to [11]; and
   (B) an organic solvent.
[13]: The composition for forming a metal-containing film of [12], further comprising one or more of (C) a crosslinking agent, (D) an acid generator, and (E) a surfactant.
[14]: The composition for forming a metal-containing film of [12] or [13], wherein the organic solvent (B) is a mixture of one or more kinds of organic solvent having a boiling point of lower than 180°C and one or more kinds of (B') a high-boiling-point solvent, being an organic solvent having a boiling point of 180°C or higher.
[15]: A patterning process for forming a pattern in a substrate to be processed, comprising the steps of:
   (I-1) applying the composition for forming a metal-containing film of any one of [12] to [14] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[16]: A patterning process for forming a pattern in a substrate to be processed, comprising the steps of:
   (II-1) forming an organic resist underlayer film on a substrate to be processed;
   (II-2) applying the composition for forming a metal-containing film of any one of [12] to [14] onto the organic resist underlayer film, followed by heating to form a metal-containing film;
   (II-3) forming a resist upper layer film on the metal-containing film by using a photoresist material;
   (II-4) subjecting the resist upper layer film to pattern exposure and then development with a developer to form a pattern in the resist upper layer film;
   (II-5) transferring the pattern to the metal-containing film by dry etching while using the resist upper layer film having the formed pattern as a mask;
   (II-6) transferring the pattern to the organic resist underlayer film by dry etching while using the metal-containing film having the transferred pattern as a mask; and
   (II-7) processing the substrate to be processed while using the organic resist underlayer film having the formed pattern as a mask to form the pattern in the substrate to be processed.
[17]: A patterning process for forming a pattern in a substrate to be processed, comprising the steps of:
   (III-1) applying the composition for forming a metal-containing film of any one of [12] to [14] onto a substrate to be processed, followed by heating to form a metal-containing film;
   (III-2) forming an inorganic hard mask middle layer film selected from a silicon-containing resist middle layer film, a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[18]: A patterning process for forming a pattern in a substrate to be processed, comprising the steps of:
   (IV-1) applying the composition for forming a metal-containing film of any one of [12] to [14] onto a substrate to be processed, followed by heating to form a metal-containing film;
   (IV-2) forming an organic middle layer film on the metal-containing film;
   (IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
   (IV-4) forming a resist upper layer film on the silicon-containing resist middle layer film or the organic thin film by using a photoresist material;
   (IV-5) subjecting the resist upper layer film to pattern exposure and then development with a developer to form a pattern in the resist upper layer film;
   (IV-6) transferring the pattern to the silicon-containing resist middle layer film or the organic thin film and the inorganic hard mask middle layer film by dry etching while using the resist upper layer film having the formed pattern as a mask;
   (IV-7) transferring the pattern to the organic middle layer film by dry etching while using the silicon-containing resist middle layer film or the inorganic hard mask middle layer film having the transferred pattern as a mask;
   (IV-8) transferring the pattern to the metal-containing film by dry etching while using the organic middle layer film as a mask; and
   (IV-9) processing the substrate to be processed while using the metal-containing film having the formed pattern as a mask to form the pattern in the substrate to be processed.
[19]: The patterning process of [15], wherein the pattern exposure in the step (I-3) is performed using EUV light.
[20]: The patterning process of [16], wherein the pattern exposure in the step (II-4) is performed using EUV light.
[21]: The patterning process of [17], wherein the pattern exposure in the step (III-5) is performed using EUV light.
[22]: The patterning process of [18], wherein the pattern exposure in the step (IV-5) is performed using EUV light.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound for forming a metal-containing film, comprising:
at least one kind of metal atom (a) selected from the group consisting of Ti, Zr, and Hf; and a polydentate ligand coordinated to the metal atom (a),
wherein the polydentate ligand is derived from a compound (b) having 1 to 50 carbon atoms and being substituted with at least one kind of halogen atom selected from the group consisting of a chlorine atom, a bromine atom, and an iodine atom.

2. The compound for forming a metal-containing film according to claim 1, wherein the compound (b) contains any of structures represented by the following general formulae (b-1) to (b-4), 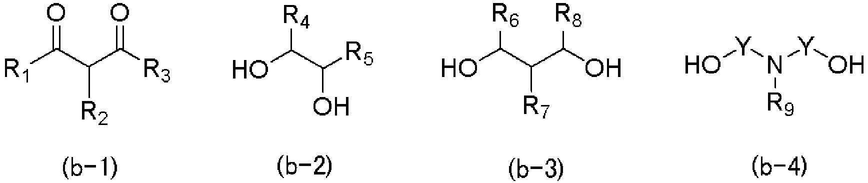
wherein R₁ to R₃ each represent a hydrogen atom or a monovalent organic group having 1 to 30 carbon atoms and optionally containing any of a chlorine atom, a bromine atom, and an iodine atom; R₄ and R₅ each represent a hydrogen atom or a monovalent organic group having 1 to 30 carbon atoms and optionally containing any of a chlorine atom, a bromine atom, and an iodine atom; R₆ to R₉ each represent a hydrogen atom or a monovalent organic group having 1 to 30 carbon atoms and optionally containing any of a chlorine atom, a bromine atom, and an iodine atom; Y represents a divalent organic group having 1 to 10 carbon atoms; the R₄ and the R₅ in the general formula (b-2), being adjacent to each other, are optionally bonded to each other to form an unsaturated or saturated cyclic structure; and compounds of the general formulae (b-1) to (b-4) contain at least one of any of a chlorine atom, a bromine atom, and an iodine atom, preferably,
wherein the compounds represented by the general formulae (b-1) to (b-4) contain at least one of an aromatic ring, a heteroaromatic ring, and an alicyclic structure, preferably,
wherein the compound represented by the general formulae (b-1) to (b-4) contains a structure represented by the following formula (1), 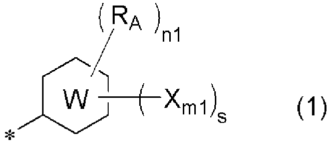
wherein Xₘ₁ represents any of a chlorine atom, a bromine atom, and an iodine atom, or a monovalent organic group having 1 to 10 carbon atoms and containing any of a chlorine atom, a bromine atom, and an iodine atom; W represents an organic group having 5 to 20 carbon atoms and containing any of an aromatic ring, a heteroaromatic ring, and an alicyclic structure; R_{A} is selected from a linear alkyl group having 1 to 10 carbon atoms, a branched alkyl group having 1 to 10 carbon atoms, an alkoxy group having 1 to 10 carbon atoms, a hydroxy group, a halogen atom, and a halogenated alkyl group having 1 to 10 carbon atoms; "s" is 1 to 5; and "n₁" is 0 to 2.

3. The compound for forming a metal-containing film according to claim 1, further comprising a ligand (c) derived from a silicon compound represented by the following general formula (2), 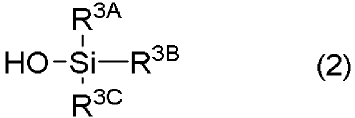
wherein R^{3A}, R^{3B}, and R^{3C} each represent any organic group selected from an organic group having 1 to 30 carbon atoms and having any crosslinking group of structures represented by the following general formulae (c-1) to (c-3), a substituted or unsubstituted alkyl group having 1 to 20 carbon atoms, and an aryl group having 1 to 20 carbon atoms, 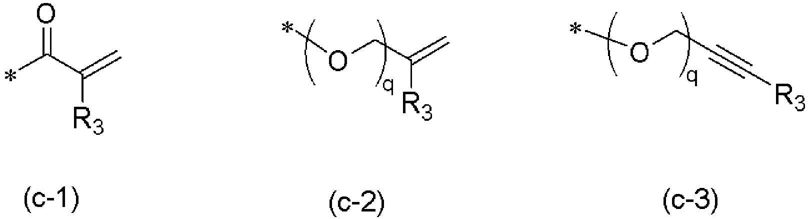
wherein R₃ represents a hydrogen atom or a monovalent organic group having 1 to 10 carbon atoms; "q" represents 0 or 1; and "*" represents an attachment point.

4. The compound for forming a metal-containing film according to claim 1, further comprising a ligand having one or more crosslinkable groups selected from a vinyl group, an allyl group, an allyloxy group, an ethynyl group, a propargyl group, a propargyloxy group, an epoxy group, and an oxetanyl group, preferably,
wherein the compound (b) further has one or more crosslinkable groups selected from a vinyl group, an allyl group, an allyloxy group, an ethynyl group, a propargyl group, a propargyloxy group, an epoxy group, and an oxetanyl group.

5. The compound for forming a metal-containing film according to claim 2, being a reaction product between: a metal-containing compound containing one or more selected from a metal compound represented by the following formula (3) and a hydrolysis product, condensate, and hydrolysis condensate of the metal compound represented by the following formula (3); and the compound represented by any of the formulae (b-1) to (b-4),
LₐMX_{b} (3)
wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR^{a}R^{b}, R^{a} and R^{b} each independently represent a hydrogen atom or a monovalent organic group having 1 to 20 carbon atoms, and a+b is 2 to 4, "a" and "b" each representing an integer of 0 to 4.

6. The compound for forming a metal-containing film according to claim 1, wherein the compound (b) contains one or more chlorine atoms.

7. The compound for forming a metal-containing film according to claim 1, wherein the compound (b) contains one or more bromine atoms.

8. The compound for forming a metal-containing film according to claim 1, wherein the compound (b) contains one or more iodine atoms.

9. A composition for forming a metal-containing film, the composition functioning as a resist underlayer film material or a resist middle layer film material used in manufacturing a semiconductor, the composition comprising:
(A) the compound for forming a metal-containing film according to any one of claims 1 to 8; and
(B) an organic solvent.

10. The composition for forming a metal-containing film according to claim 9, further comprising one or more of (C) a crosslinking agent, (D) an acid generator, and (E) a surfactant.

11. The composition for forming a metal-containing film according to claim 9, wherein the organic solvent (B) is a mixture of one or more kinds of organic solvent having a boiling point of lower than 180°C and one or more kinds of (B') a high-boiling-point solvent, being an organic solvent having a boiling point of 180°C or higher.

12. A patterning process for forming a pattern in a substrate to be processed, comprising the steps of:
(I-1) applying the composition for forming a metal-containing film according to claim 9 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed, preferably,
wherein the pattern exposure in the step (I-3) is performed using EUV light.

13. A patterning process for forming a pattern in a substrate to be processed, comprising the steps of:
(II-1) forming an organic resist underlayer film on a substrate to be processed;
(II-2) applying the composition for forming a metal-containing film according to claim 9 onto the organic resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed, preferably,
wherein the pattern exposure in the step (II-4) is performed using EUV light.

14. A patterning process for forming a pattern in a substrate to be processed, comprising the steps of:
(III-1) applying the composition for forming a metal-containing film according to claim 9 onto a substrate to be processed, followed by heating to form a metal-containing film;
(III-2) forming an inorganic hard mask middle layer film selected from a silicon-containing resist middle layer film, a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed, preferably,
wherein the pattern exposure in the step (III-5) is performed using EUV light.

15. A patterning process for forming a pattern in a substrate to be processed, comprising the steps of:
(IV-1) applying the composition for forming a metal-containing film according to claim 9 onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed, preferably,
wherein the pattern exposure in the step (IV-5) is performed using EUV light.
